(19) Europäisches Patentamt
European Patent Office
Office européen des brevets

(11) **EP 4 645 833 A1**

(12) **EUROPEAN PATENT APPLICATION**
published in accordance with Art. 153(4) EPC

(43) Date of publication:
**05.11.2025 Bulletin 2025/45**

(21) Application number: **23915336.4**

(22) Date of filing: **12.01.2023**

(51) International Patent Classification (IPC):
***H04L 69/04*** *(2022.01)*

(52) Cooperative Patent Classification (CPC):
**H04L 69/04**

(86) International application number:
**PCT/CN2023/071916**

(87) International publication number:
**WO 2024/148566 (18.07.2024 Gazette 2024/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
- **DU, Yuqing
  Shenzhen, Guangdong 518129 (CN)**
- **MA, Mengyao
  Shenzhen, Guangdong 518129 (CN)**
- **BI, Xiaoyan
  Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **DATA COMPRESSION TRANSMISSION METHOD AND APPARATUS, AND DEVICE AND STORAGE MEDIUM**

(57) This application provides a data compression and transmission method, an apparatus, a device, and a storage medium. A first apparatus obtains M pieces of first data. One piece of subdata in the first data corresponds to one first sparse matrix, the first sparse matrix represents one piece of corresponding subdata in the first data based on a first dictionary matrix, and the first dictionary matrix includes features of M pieces of subdata respectively corresponding to the M pieces of first data. The first apparatus outputs compressed data of the M first sparse matrices. M is an integer greater than 1. In this way, effective and reliable data compression and transmission can be implemented in a transmission scenario with a large data amount.

FIG. 3

**Description**

**TECHNICAL FIELD**

This application relates to the field of communication technologies, and in particular, to a data compression and transmission method, an apparatus, a device, and a storage medium.

**BACKGROUND**

Currently, in some communication scenarios, for example, a point cloud data transmission scenario or an artificial intelligence (artificial intelligence, AI) model data (which is briefly referred to as AI model data below) transmission scenario, when there is a large amount of data transmitted between communication devices, a large quantity of transmission resources are occupied, and a transmission delay is increased. In view of this, data compression may be performed on to-be-transmitted data in a scalar quantization manner or a vector quantization manner before data transmission, and then compressed data is transmitted, to save transmission resources and reduce a transmission delay. However, using an existing manner to compress the to-be-transmitted data has a compression rate, and compressed data has a large data loss. Therefore, how to implement effective and reliable data compression and transmission is an urgent problem to be resolved currently.

**SUMMARY**

Embodiments of this application provide a data compression and transmission method, an apparatus, a device, and a storage medium, to implement effective and reliable data compression and transmission.

According to a first aspect, an embodiment of this application provides a data compression and transmission method, including: A first apparatus obtains M pieces of first data. One piece of subdata in the first data corresponds to one first sparse matrix, the first sparse matrix represents one piece of corresponding subdata in the first data based on a first dictionary matrix, and the first dictionary matrix includes features of M pieces of subdata respectively corresponding to the M pieces of first data. The first apparatus outputs compressed data of the M first sparse matrices. M is an integer greater than 1.

According to the data compression and transmission method provided in the first aspect, dictionary learning is performed on the M pieces of subdata respectively corresponding to the M pieces of first data based on one first dictionary matrix, to obtain a sparse representation of each piece of subdata, to implement effective and reliable data compression and transmission in a transmission scenario with a large data amount.

In a possible implementation, that the first apparatus outputs the compressed data of the M first sparse matrices includes: The first apparatus determines a first matrix based on the M first sparse matrices. The first apparatus performs low-rank approximation on the first matrix, to obtain first compressed data of the M first sparse matrices. The first apparatus outputs the first compressed data.

According to the data compression and transmission method provided in this implementation, joint compression is performed on the M first sparse matrices through low-rank approximation, to further improve a compression rate.

In a possible implementation, that the first apparatus determines the first matrix based on the M first sparse matrices includes: The first apparatus combines the M first sparse matrices, to obtain the first matrix; or the first apparatus performs data compression on at least one of the M first sparse matrices, and combines M first sparse matrices obtained through data compression, to obtain a first matrix.

According to the data compression and transmission method provided in this implementation, when the first apparatus combines the M first sparse matrices, to obtain the first matrix, there is high processing efficiency, and the first apparatus performs data compression on the at least one first sparse matrix, and then combines the M first sparse matrices, to obtain the first matrix, to further improve the compression rate.

In a possible implementation, that the first apparatus performs data compression on the at least one of the M first sparse matrices includes: For one of the M first sparse matrices, the first apparatus sets a value of a first element in the one first sparse matrix to a first value based on first location indication information. The first location indication information indicates a location of an element, in the first sparse matrix, capable of representing one piece of corresponding subdata, and the first element is incapable of representing one piece of subdata in the first data.

According to the data compression and transmission method provided in this implementation, the element that is capable of representing one piece of corresponding subdata is selected from the first sparse matrix, to implement data compression on the first sparse matrix.

In a possible implementation, that the first apparatus performs low-rank approximation on the first matrix, to obtain the first compressed data of the M first sparse matrices includes: The first apparatus performs singular value decomposition on the first matrix, to obtain K feature values and feature vectors respectively corresponding to the K feature values. The K feature values and the feature vectors respectively corresponding to the K feature values represent the first matrix. The first apparatus uses $K_0$ feature values in the K feature values and feature vectors respectively corresponding to the $K_0$ feature values as the first compressed data of the M first sparse matrices.

According to the data compression and transmission method provided in this implementation, the $K_0$ feature values and the feature vectors respectively corresponding to the $K_0$ feature values are selected from feature values obtained through singular value decomposition, to implement low-rank approximation of the M first sparse matrices, and improve a compression rate of the M pieces of first data.

In a possible implementation, the method further includes: The first apparatus outputs second compressed data of the M first sparse matrices. The second compressed data includes $K_1$ feature values other than the $K_0$ feature values in the K feature values and feature vectors respectively corresponding to the $K_1$ feature values.

According to the data compression and transmission method provided in this implementation, the $K_1$ feature values and the feature vectors respectively corresponding to the $K_1$ feature values are transmitted, to supplement the first compressed data, so that a second apparatus can accurately construct the M pieces of first data.

In a possible implementation, that the first apparatus outputs the compressed data of the M first sparse matrices includes: The first apparatus outputs first residual information. The first residual information is determined based on information about a $j^{th}$ first sparse matrix and information about an $i^{th}$ first sparse matrix in the M first sparse matrices. Herein, i is less than j, and both i and j are positive integers.

According to the data compression and transmission method provided in this implementation, joint compression is performed on the M first sparse matrices in a residual-based manner, to further improve the compression rate of the M pieces of first data.

In a possible implementation, that the first apparatus outputs the first residual information includes: The first apparatus determines a similarity between the $j^{th}$ first sparse matrix and the $i^{th}$ first sparse matrix in the M first sparse matrices. The first apparatus outputs the first residual information when the similarity is less than or equal to a second similarity threshold.

According to the data compression and transmission method provided in this implementation, when the similarity between the $j^{th}$ first sparse matrix and the $i^{th}$ first sparse matrix is less than or equal to the second similarity threshold, the first residual information is output, to avoid a case in which the first residual information is still output when the $j^{th}$ first sparse matrix is similar to the $i^{th}$ first sparse matrix, and improve the compression rate of the M pieces of first data.

In a possible implementation, the information about the $i^{th}$ first sparse matrix is obtained by decompressing compressed data of the $i^{th}$ first sparse matrix.

According to the data compression and transmission method provided in this implementation, when the $j^{th}$ first sparse matrix needs to be transmitted, the first residual information is determined based on the recovered $i^{th}$ first sparse matrix and the $j^{th}$ first sparse matrix, so that the second apparatus can accurately construct the $j^{th}$ first sparse matrix based on the first residual information.

Optionally, the first residual information includes a first residual element sequence, the first residual element sequence represents a residual matrix between the information about the $j^{th}$ first sparse matrix and the information about the $i^{th}$ first sparse matrix, i is less than j, and both i and j are positive integers.

Optionally, the first residual information further includes second location indication information, and the second location indication information indicates a location of a residual element whose absolute value is greater than or equal to a first residual threshold in the residual matrix between the information about the $j^{th}$ first sparse matrix and the information about the $i^{th}$ first sparse matrix.

In a possible implementation, the method further includes: The first apparatus outputs second residual information. The second residual information is determined based on the information about the $j^{th}$ first sparse matrix and the information about the $i^{th}$ first sparse matrix. The second residual information includes third location indication information and a second residual element sequence, the third location indication information indicates a residual element less than or equal to the first residual threshold and greater than or equal to a second residual threshold in the residual matrix between the information about the $j^{th}$ first sparse matrix and the information about the $i^{th}$ first sparse matrix, and the second residual element sequence includes a residual element less than or equal to the first residual threshold and greater than or equal to the second residual threshold in the residual matrix.

According to the data compression and transmission method provided in this implementation, the second residual information transmitted in an incremental process may supplement the first residual information, to enrich the residual information, so that the second apparatus can more accurately construct the $j^{th}$ first sparse matrix based on the first residual information and the second residual information.

In a possible implementation, the method further includes: For a $k^{th}$ piece of first data $Y_k$ in the M pieces of first data, the first apparatus decomposes one piece of subdata in the $k^{th}$ piece of first data $Y_k$ into the first dictionary matrix and a $k^{th}$ first sparse matrix. Herein, k is a positive integer less than or equal to M. The first apparatus determines M-1 first sparse matrices other than the $k^{th}$ first sparse matrix based on the first dictionary matrix.

According to the data compression and transmission method provided in this implementation, accuracy is higher when the first dictionary matrix obtained by decomposing one of the M pieces of subdata is used for data compression and data decompression.

In a possible implementation, for a $p^{th}$ piece of first data and a $q^{th}$ piece of first data in the M pieces of first data, a similarity between one piece of subdata in the $p^{th}$ piece of first data and one piece of subdata in the $q^{th}$ piece of first data is greater than or equal to a first similarity threshold; and both p and q are positive integers, and p is not equal to q.

According to the data compression and transmission method provided in this implementation, subdata in different first data is similar, so that data compression of the M first sparse matrices is more reliable.

In a possible implementation, the M pieces of first data are respectively data in M time units, one piece of first data includes N pieces of subdata obtained through division based on a spatial location relationship, and N is a positive integer; or the M pieces of first data are data in h time units, the data in the h time units is sorted based on a spatial location relationship, to obtain the M pieces of first data, one piece of first data includes N pieces of subdata, and h is a positive integer; and a similarity between a spatial location of one piece of subdata in the $p^{th}$ piece of first data and a spatial location of one piece of subdata in the $q^{th}$ piece of first data in the M pieces of first data is greater than or equal to the first similarity threshold.

According to the data compression and transmission method provided in this implementation, to-be-transmitted data is divided to obtain the M pieces of first data, so that sparseness of a sparse matrix (for example, the M first sparse matrices) obtained through dictionary learning can be improved, and different first data is correlated, to facilitate subsequent data compression processing.

In a possible implementation, the method further includes: The first apparatus sends the first dictionary matrix to the second apparatus; or the first apparatus receives the first dictionary matrix sent by the second apparatus.

According to the data compression and transmission method provided in this implementation, the first dictionary matrix is synchronized between the first apparatus and the second apparatus, so that the M first sparse matrices output by the first apparatus can be used by the second apparatus to accurately construct the M pieces of first data.

In a possible implementation, that the first apparatus outputs the first compressed data includes: The first apparatus performs compression processing on the first compressed data. The compression processing includes quantization and/or entropy encoding. The first apparatus outputs first compressed data obtained through compression processing.

According to the data compression and transmission method provided in this implementation, a compression rate of the M first sparse matrices is further improved.

In a possible implementation, that the first apparatus outputs the first residual information includes: The first apparatus performs compression processing on the first residual information. The compression processing includes quantization and/or entropy encoding. The first apparatus outputs first residual information obtained through compression processing.

According to the data compression and transmission method provided in this implementation, the compression rate of the M first sparse matrices is further improved.

In a possible implementation, the method further includes: The first apparatus sends first indication information to the second apparatus; or the first apparatus receives first indication information sent by the second apparatus. The first indication information indicates at least one of the following: a quantity $K_0$ of features of low-rank approximation; a quantity M of pieces of first data; a capability threshold, where the capability threshold is used to determine whether an element in the first sparse matrix is capable of representing one piece of corresponding subdata in the first data; the first residual threshold, where the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; a proportion of elements, in one of the M first sparse matrices, capable of representing one piece of corresponding subdata in the first data; a data loss of the first compressed data relative to the M first sparse matrices, where the first compressed data is determined based on the M first sparse matrices; a compression processing parameter, where the compression processing includes quantization and/or entropy encoding, and the compression processing parameter includes at least one of quantization precision, a quantization codebook, and an encoding manner; and whether to send the first residual information, where the first residual information is determined based on the information about the $j^{th}$ first sparse matrix and the information about the $i^{th}$ first sparse matrix in the M first sparse matrices.

According to the data compression and transmission method provided in this implementation, data compression and transmission is flexibly indicated.

In a possible implementation, the method further includes: The first apparatus determines at least one of the following based on a first time-frequency resource of the M pieces of first data: a capability threshold, where the capability threshold is used to determine whether an element in the first sparse matrix is capable of representing one piece of corresponding subdata in the first data; the first residual threshold, where the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; and the compression processing parameter, where the compression processing includes quantization and/or entropy encoding, and the compression processing parameter includes at least one of the quantization precision, the quantization codebook, and the encoding manner.

According to the data compression and transmission method provided in this implementation, one or more thresholds and/or the compression processing parameter are/is implicitly configured based on the first time-frequency resource of the M pieces of first data, to reduce overheads of configuration signaling.

In a possible implementation, the method further includes: The first apparatus receives first configuration information sent by the second apparatus. The first configuration information is used to configure the first time-frequency resource.

According to the data compression and transmission method provided in this implementation, a transmission resource is flexibly configured.

In a possible implementation, the method further includes: The first apparatus sends a compression and transmission request to the second apparatus. The compression and transmission request carries a data type of the M pieces of first data, and the data type includes point cloud data and/or artificial intelligence AI data.

In this implementation, the second apparatus determines, based on the data type, a time-frequency resource used to transmit compressed data of the first data, so that the first time-frequency resource configured by the second apparatus satisfies the data type, to facilitate compression and transmission.

In a possible implementation, the method further includes: The first apparatus sends second indication information to the second apparatus; or the first apparatus receives second indication information sent by the second apparatus. The second indication information indicates at least one of the following: a quantity $K_1$ of features of low-rank approximation; and the second residual threshold, where the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

According to the data compression and transmission method provided in this implementation, data compression and transmission in an incremental transmission process is flexibly indicated.

In a possible implementation, the method further includes: The first apparatus determines the second residual threshold based on a second time-frequency resource of the M pieces of first data. The second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

According to the data compression and transmission method provided in this implementation, overheads of configuration signaling are reduced.

In a possible implementation, the method further includes: The first apparatus receives second configuration information sent by the second apparatus. The second configuration information is used to configure the second time-frequency resource.

According to the data compression and transmission method provided in this implementation, a transmission resource in an incremental transmission process is flexibly configured.

According to a second aspect, an embodiment of this application provides a data compression and transmission method, including: A second apparatus receives compressed data of M first sparse matrices. The first sparse matrix represents corresponding subdata in first data based on a first dictionary matrix, the first dictionary matrix includes features of M pieces of subdata respectively corresponding to M pieces of first data, and one piece of subdata in the first data corresponds to one first sparse matrix. The second apparatus outputs decompression information based on the compressed data.

In a possible implementation, the compressed data includes first compressed data, and that the second apparatus outputs the decompression information based on the compressed data includes: The second apparatus performs low-rank matrix recovery based on the first compressed data, to obtain a first matrix. The second apparatus determines the M first sparse matrices based on the first matrix. The second apparatus constructs the M pieces of first data based on the M first sparse matrices and the first dictionary matrix. The second apparatus outputs the M pieces of first data.

In a possible implementation, that the second apparatus determines the M first sparse matrices based on the first matrix includes: The second apparatus splits the first matrix, to obtain the M first sparse matrices; or the second apparatus splits the first matrix, to obtain decompression information of the M first sparse matrices, and performs data decompression on at least one of the M first sparse matrices based on the information about the M first sparse matrices.

In a possible implementation, that the second apparatus performs data decompression on the at least one of the M first sparse matrices includes: For one of the M first sparse matrices, the second apparatus performs data decompression on the first sparse matrix based on first location indication information. The first location indication information indicates a location of an element, in the first sparse matrix, capable of representing one piece of corresponding subdata, and the first element is incapable of representing one piece of subdata in the first data.

In a possible implementation, the first compressed data includes $K_0$ feature values and feature vectors respectively corresponding to the $K_0$ feature values, and that the second apparatus performs low-rank matrix recovery based on the first compressed data, to obtain the first matrix includes: The second apparatus performs low-rank matrix recovery based on the $K_0$ feature values and the feature vectors respectively corresponding to the $K_0$ feature values, to obtain the first matrix.

In a possible implementation, the compressed data further includes second compressed data, the second compressed data includes $K_1$ feature values and feature vectors respectively corresponding to the $K_1$ feature values, and the $K_1$ feature values are different from the $K_0$ feature values.

In a possible implementation, the compressed data includes first residual information, the first residual information is determined based on information about a $j^{th}$ first sparse matrix and information about an $i^{th}$ first sparse matrix in the M first sparse matrices, and that the second apparatus outputs the decompression information based on the compressed data includes: The second apparatus constructs the $j^{th}$ first sparse matrix based on the first residual information and the $i^{th}$ first sparse matrix. The second apparatus constructs the M pieces of first data based on the $j^{th}$ first sparse matrix. The second apparatus outputs the M pieces of first data. Herein, i is less than j, and both and i and j are positive integers.

In a possible implementation, the information about the $i^{th}$ first sparse matrix is obtained by decompressing compressed data of the $i^{th}$ first sparse matrix.

In a possible implementation, the first residual information includes a first residual element sequence, the first residual element sequence represents a residual matrix between the information about the $j^{th}$ first sparse matrix and the information about the $i^{th}$ first sparse matrix, i is less than j, and both i and j are positive integers.

In a possible implementation, the first residual information further includes second location indication information, and the second location indication information indicates a location of a residual element whose absolute value is greater than or equal to a first residual threshold in the residual matrix between the information about the $j^{th}$ first sparse matrix and the information about the $i^{th}$ first sparse matrix.

In a possible implementation, the compressed data further includes second residual information, and the second residual information is determined based on the information about the $j^{th}$ first sparse matrix and the information about the $i^{th}$ first sparse matrix. The second residual information includes third location indication information and a second residual element sequence, the third location indication information indicates a residual element less than or equal to the first residual threshold and greater than or equal to a second residual threshold in the residual matrix between the information about the $j^{th}$ first sparse matrix and the information about the $i^{th}$ first sparse matrix, and the second residual element sequence includes a residual element less than or equal to the first residual threshold and greater than or equal to the second residual threshold in the residual matrix.

In a possible implementation, for a $p^{th}$ piece of first data and a $q^{th}$ piece of first data in the M pieces of first data, a similarity between one piece of subdata in the $p^{th}$ piece of first data and one piece of subdata in the $q^{th}$ piece of first data is greater than or equal to a first similarity threshold; and both p and q are positive integers, and p is not equal to q.

In a possible implementation, the M pieces of first data are respectively data in M time units; or the M pieces of first data are data in h time units, the data in the h time units is sorted based on a spatial location relationship, to obtain the M pieces of first data, one piece of first data includes N pieces of subdata, and h is a positive integer; and a similarity between a spatial location of one piece of subdata in the $p^{th}$ piece of first data and a spatial location of one piece of subdata in the $q^{th}$ piece of first data in the M pieces of first data is greater than or equal to the first similarity threshold.

In a possible implementation, the method further includes: The second apparatus receives the first dictionary matrix sent by the first apparatus; or the second apparatus sends the first dictionary matrix to the first apparatus.

In a possible implementation, the method further includes: The second apparatus receives first indication information sent by the first apparatus; or the second apparatus sends first indication information to the first apparatus. The first indication information indicates at least one of the following: a quantity $K_0$ of features of low-rank approximation; a quantity M of pieces of first data; a capability threshold, where the capability threshold is used to determine whether an element in the first sparse matrix is capable of representing one piece of corresponding subdata in the first data; the first residual threshold, where the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; a proportion of elements, in one of the M first sparse matrices, capable of representing one piece of corresponding subdata in the first data; a data loss of the first compressed data relative to the M first sparse matrices, where the first compressed data is determined based on the M first sparse matrices; a compression processing parameter, where the compression processing includes quantization and/or entropy encoding, and the compression processing parameter includes at least one of quantization precision, a quantization codebook, and an encoding manner; and whether to send the first residual information, where the first residual information is determined based on the information about the $j^{th}$ first sparse matrix and the information about the $i^{th}$ first sparse matrix in the M first sparse matrices.

In a possible implementation, the method further includes: The second apparatus sends first configuration information to the first apparatus. The first configuration information is used to configure a first time-frequency resource of the M pieces of first data.

In a possible implementation, the method further includes: The second apparatus receives a compression and transmission request sent by the first apparatus. The compression and transmission request carries a data type of the M pieces of first data, and the data type includes point cloud data and/or AI data.

In a possible implementation, the method further includes: The second apparatus receives second indication information sent by the first apparatus; or the second apparatus sends second indication information to the first apparatus. The second indication information indicates at least one of the following: a quantity $K_1$ of features of low-rank approximation; and the second residual threshold, where the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

In a possible implementation, the method further includes: The first apparatus receives second configuration information sent by the second apparatus. The second configuration information is used to configure a second time-frequency resource of the M pieces of first data.

For beneficial effects of the data compression and transmission method provided in the second aspect and the possible implementations of the second aspect, refer to beneficial effects achieved by the first aspect and the possible implementations of the first aspect. Details are not described herein again.

According to a third aspect, an embodiment of this application provides a communication apparatus, including: a processing module, configured to obtain M pieces of first data, where one piece of subdata in the first data corresponds to one first sparse matrix, the first sparse matrix represents one piece of corresponding subdata in the first data based on a first dictionary matrix, and the first dictionary matrix includes features of M pieces of subdata respectively corresponding to the M pieces of first data; and a transceiver module, configured to output compressed data of the M first sparse matrices, where M is an integer greater than 1.

In a possible implementation, the processing module is further configured to determine a first matrix based on the M first sparse matrices. The first apparatus performs low-rank approximation on the first matrix, to obtain first compressed data of the M first sparse matrices. The transceiver module is configured to output the first compressed data.

In a possible implementation, the processing module is specifically configured to: combine the M first sparse matrices, to obtain the first matrix; or perform, for the first apparatus, data compression on at least one of the M first sparse matrices, and combine M first sparse matrices obtained through data compression, to obtain the first matrix.

In a possible implementation, the processing module is specifically configured to: for one of the M first sparse matrices, set a value of a first element in the one first sparse matrix to a first value based on first location indication information. The first location indication information indicates a location of an element, in the first sparse matrix, capable of representing one piece of corresponding subdata, and the first element is incapable of representing one piece of subdata in the first data.

In a possible implementation, the processing module is specifically configured to: perform singular value decomposition on the first matrix, to obtain K feature values and feature vectors respectively corresponding to the K feature values, where the K feature values and the feature vectors respectively corresponding to the K feature values represent the first matrix; and use $K_0$ feature values in the K feature values and feature vectors respectively corresponding to the $K_0$ feature values as the first compressed data of the M first sparse matrices.

In a possible implementation, the transceiver module is further configured to output second compressed data of the M first sparse matrices. The second compressed data includes $K_1$ feature values other than the $K_0$ feature values in the K feature values and feature vectors respectively corresponding to the $K_1$ feature values.

In a possible implementation, the transceiver module is specifically configured to output first residual information. The first residual information is determined based on information about a $j^{th}$ first sparse matrix and information about an $i^{th}$ first sparse matrix in the M first sparse matrices. Herein, i is less than j, and both i and j are positive integers.

In a possible implementation, the processing module is further configured to determine a similarity between the $j^{th}$ first sparse matrix and the $i^{th}$ first sparse matrix in the M first sparse matrices; and the transceiver module outputs the first residual information when the similarity is less than or equal to a second similarity threshold.

In a possible implementation, the information about the $i^{th}$ first sparse matrix is obtained by decompressing compressed data of the $i^{th}$ first sparse matrix.

In a possible implementation, the first residual information includes a first residual element sequence, the first residual element sequence represents a residual matrix between the information about the $j^{th}$ first sparse matrix and the information about the $i^{th}$ first sparse matrix, i is less than j, and both i and j are positive integers.

In a possible implementation, the first residual information further includes second location indication information, and the second location indication information indicates an absolute value is greater than or equal to in the residual matrix between the information about the $j^{th}$ first sparse matrix and the information about the $i^{th}$ first sparse matrix.

In a possible implementation, the transceiver module is further configured to output second residual information.

The second residual information is determined based on the information about the $j^{th}$ first sparse matrix and the information about the $i^{th}$ first sparse matrix. The second residual information includes third location indication information and a second residual element sequence, the third location indication information indicates a residual element less than or equal to the first residual threshold and greater than or equal to a second residual threshold in the residual matrix between the information about the $j^{th}$ first sparse matrix and the information about the $i^{th}$ first sparse matrix, and the second residual element sequence includes a residual element less than or equal to the first residual threshold and greater than or equal to the second residual threshold in the residual matrix.

In a possible implementation, the processing module is further configured to: for a $k^{th}$ piece of first data $Y_k$ in the M pieces of first data, the first apparatus decomposes one piece of subdata in the $k^{th}$ piece of first data $Y_k$ into the first dictionary matrix and a $k^{th}$ first sparse matrix. Herein, k is a positive integer less than or equal to M. The first apparatus determines M-1 first sparse matrices other than the $k^{th}$ first sparse matrix based on the first dictionary matrix.

In a possible implementation, for a $p^{th}$ piece of first data and a $q^{th}$ piece of first data in the M pieces of first data, a similarity between one piece of subdata in the $p^{th}$ piece of first data and one piece of subdata in the $q^{th}$ piece of first data is greater than or equal to a first similarity threshold; and both p and q are positive integers, and p is not equal to q.

In a possible implementation, the M pieces of first data are respectively data in M time units; or the M pieces of first data are data in h time units, the data in the h time units is sorted based on a spatial location relationship, to obtain the M pieces of first data, one piece of first data includes N pieces of subdata, and h is a positive integer; and a similarity between a spatial location of one piece of subdata in the $p^{th}$ piece of first data and a spatial location of one piece of subdata in the $q^{th}$ piece of first data in the M pieces of first data is greater than or equal to the first similarity threshold.

In a possible implementation, the transceiver module is further configured to: send the first dictionary matrix to a second apparatus; or receive the first dictionary matrix sent by the second apparatus.

In a possible implementation, the transceiver module is specifically configured to: perform compression processing on the first compressed data, where the compression processing includes quantization and/or entropy encoding; and output first compressed data obtained through compression processing.

In a possible implementation, the transceiver module is specifically configured to: perform compression processing on the first residual information, where the compression processing includes quantization and/or entropy encoding; and output first residual information obtained through compression processing.

In a possible implementation, the following is further included: the transceiver module is further configured to: send first indication information to the second apparatus; or receive first indication information sent by the second apparatus. The first indication information indicates at least one of the following: a quantity $K_0$ of features of low-rank approximation; a quantity M of pieces of first data; a capability threshold, where the capability threshold is used to determine whether an element in the first sparse matrix is capable of representing one piece of corresponding subdata in the first data; the first residual threshold, where the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; a proportion of elements, in one of the M first sparse matrices, capable of representing one piece of corresponding subdata in the first data; a data loss of the first compressed data relative to the M first sparse matrices, where the first compressed data is determined based on the M first sparse matrices; a compression processing parameter, where the compression processing includes quantization and/or entropy encoding, and the compression processing parameter includes at least one of quantization precision, a quantization codebook, and an encoding manner; and whether to send the first residual information, where the first residual information is determined based on the information about the $j^{th}$ first sparse matrix and the information about the $i^{th}$ first sparse matrix in the M first sparse matrices.

In a possible implementation, the processing module is further configured to determine at least one of the following based on a first time-frequency resource of the M pieces of first data: a capability threshold, where the capability threshold is used to determine whether an element in the first sparse matrix is capable of representing one piece of corresponding subdata in the first data; the first residual threshold, where the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; and the compression processing parameter, where the compression processing includes quantization and/or entropy encoding, and the compression processing parameter includes at least one of the quantization precision, the quantization codebook, and the encoding manner.

In a possible implementation, the transceiver module is further configured to receive first configuration information sent by the second apparatus. The first configuration information is used to configure the first time-frequency resource.

In a possible implementation, the transceiver module is further configured to send a compression and transmission request to the second apparatus. The compression and transmission request carries a data type of the M pieces of first data, and the data type includes point cloud data and/or AI data.

In a possible implementation, the transceiver module is further configured to: send second indication information to the second apparatus; or receive second indication information sent by the second apparatus. The second indication information indicates at least one of the following: a quantity $K_1$ of features of low-rank approximation; and the second residual threshold, where the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

In a possible implementation, the processing module is further configured to determine the second residual threshold based on a second time-frequency resource of the M pieces of first data. The second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

In a possible implementation, the transceiver module is further configured to receive second configuration information sent by the second apparatus. The second configuration information is used to configure the second time-frequency resource.

For beneficial effects of the communication apparatus provided in the third aspect and the possible implementations of the third aspect, refer to beneficial effect achieved by the first aspect and the possible implementations of the first aspect. Details are not described herein again.

According to a fourth aspect, an embodiment of this application provides a communication apparatus, including: a transceiver module, configured to receive compressed data of M first sparse matrices, where the first sparse matrix represents corresponding subdata in first data based on a first dictionary matrix, the first dictionary matrix includes features of M pieces of subdata respectively corresponding to M pieces of first data, and one piece of subdata in the first data corresponds to one first sparse matrix; and a processing module, configured to output decompression information based on the compressed data.

In a possible implementation, the compressed data includes first compressed data, and the processing module is specifically configured to: perform low-rank matrix recovery based on the first compressed data, to obtain a first matrix; determine the M first sparse matrices based on the first matrix; construct the M pieces of first data based on the M first sparse matrices and the first dictionary matrix; and output, for the second apparatus, the M pieces of first data.

In a possible implementation, the processing module is specifically configured to: split the first matrix, to obtain the M first sparse matrices; or split the first matrix, to obtain decompression information of the M first sparse matrices, and perform data decompression on at least one of the M first sparse matrices based on the information about the M first sparse matrices.

In a possible implementation, the processing module is specifically configured to: for one of the M first sparse matrices, perform data decompression on the first sparse matrix based on first location indication information. The first location indication information indicates a location of an element, in the first sparse matrix, capable of representing one piece of corresponding subdata, and the first element is incapable of representing one piece of subdata in the first data.

In a possible implementation, the first compressed data includes $K_0$ feature values and feature vectors respectively corresponding to the $K_0$ feature values, and that the second apparatus performs low-rank matrix recovery based on the first compressed data, to obtain the first matrix includes: The second apparatus performs low-rank matrix recovery based on the $K_0$ feature values and the feature vectors respectively corresponding to the $K_0$ feature values, to obtain the first matrix.

In a possible implementation, the compressed data further includes second compressed data, the second compressed data includes $K_1$ feature values and feature vectors respectively corresponding to the $K_1$ feature values, and the $K_1$ feature values are different from the $K_0$ feature values.

In a possible implementation, the compressed data includes first residual information, the first residual information is determined based on information about a $j^{th}$ first sparse matrix and information about an $i^{th}$ first sparse matrix in the M first sparse matrices, and that the second apparatus outputs the decompression information based on the compressed data includes: The second apparatus constructs the $j^{th}$ first sparse matrix based on the first residual information and the $i^{th}$ first sparse matrix. The second apparatus constructs the M pieces of first data based on the $j^{th}$ first sparse matrix. The second apparatus outputs the M pieces of first data. Herein, i is less than j, and both and i and j are positive integers.

In a possible implementation, the information about the $i^{th}$ first sparse matrix is obtained by decompressing compressed data of the $i^{th}$ first sparse matrix.

In a possible implementation, the first residual information includes a first residual element sequence, the first residual element sequence represents a residual matrix between the information about the $j^{th}$ first sparse matrix and the information about the $i^{th}$ first sparse matrix, i is less than j, and both i and j are positive integers.

In a possible implementation, the first residual information further includes second location indication information, and the second location indication information indicates a location of a residual element whose absolute value is greater than or equal to a first residual threshold in the residual matrix between the information about the $j^{th}$ first sparse matrix and the information about the $i^{th}$ first sparse matrix.

In a possible implementation, the compressed data further includes second residual information, and the second residual information is determined based on the information about the $j^{th}$ first sparse matrix and the information about the $i^{th}$ first sparse matrix. The second residual information includes third location indication information and a second residual element sequence, the third location indication information indicates a residual element less than or equal to the first residual threshold and greater than or equal to a second residual threshold in the residual matrix between the information about the $j^{th}$ first sparse matrix and the information about the $i^{th}$ first sparse matrix, and the second residual element sequence includes a residual element less than or equal to the first residual threshold and greater than or equal to the second residual threshold in the residual matrix.

In a possible implementation, for a $p^{th}$ piece of first data and a $q^{th}$ piece of first data in the M pieces of first data, a similarity between one piece of subdata in the $p^{th}$ piece of first data and one piece of subdata in the $q^{th}$ piece of first data is greater than or equal to a first similarity threshold; and both p and q are positive integers, and p is not equal to q.

In a possible implementation, the M pieces of first data are respectively data in M time units; or the M pieces of first data are data in h time units, the data in the h time units is sorted based on a spatial location relationship, to obtain the M pieces of first data, one piece of first data includes N pieces of subdata, and h is a positive integer; and a similarity between a spatial location of one piece of subdata in the $p^{th}$ piece of first data and a spatial location of one piece of subdata in the $q^{th}$ piece of first data in the M pieces of first data is greater than or equal to the first similarity threshold.

In a possible implementation, the transceiver module is further configured to: receive the first dictionary matrix sent by a first apparatus; or send the first dictionary matrix to the first apparatus.

In a possible implementation, the transceiver module is further configured to: receive first indication information sent by the first apparatus; or send first indication information to the first apparatus. The first indication information indicates at least one of the following: a quantity $K_0$ of features of low-rank approximation; a quantity M of pieces of first data; a capability threshold, where the capability threshold is used to determine whether an element in the first sparse matrix is capable of representing one piece of corresponding subdata in the first data; the first residual threshold, where the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; a proportion of elements, in one of the M first sparse matrices, capable of representing one piece of corresponding subdata in the first data; a data loss of the first compressed data relative to the M first sparse matrices, where the first compressed data is determined based on the M first sparse matrices; a compression processing parameter, where the compression processing includes quantization and/or entropy encoding, and the compression processing parameter includes at least one of quantization precision, a quantization codebook, and an encoding manner; and whether to send the first residual information, where the first residual information is determined based on the information about the $j^{th}$ first sparse matrix and the information about the $i^{th}$ first sparse matrix in the M first sparse matrices.

In a possible implementation, the transceiver module is further configured to send first configuration information to the first apparatus. The first configuration information is used to configure a first time-frequency resource of the M pieces of first data.

In a possible implementation, the transceiver module is further configured to receive a compression and transmission request sent by the first apparatus. The compression and transmission request carries a data type of the M pieces of first data, and the data type includes point cloud data and/or artificial intelligence AI data.

In a possible implementation, the transceiver module is further configured to: receive second indication information sent by the first apparatus; or send second indication information to the first apparatus. The second indication information indicates at least one of the following: a quantity $K_1$ of features of low-rank approximation; and the second residual threshold, where the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

In a possible implementation, the transceiver module is further configured to receive second configuration information sent by the second apparatus. The second configuration information is used to configure a second time-frequency resource of the M pieces of first data.

For beneficial effects of the communication apparatus provided in the fourth aspect and the possible implementations of the fourth aspect, refer to beneficial effects achieved by the first aspect and the possible implementations of the first aspect. Details are not described herein again.

According to a fifth aspect, an embodiment of this application provides a communication apparatus, including: a processor. The processor is configured to perform the method in the first aspect, the second aspect, or the possible implementations by running a computer program or by using a logic circuit.

In a possible implementation, a memory is further included, and the memory is configured to store the computer program.

In a possible implementation, a communication interface is further included, and the communication interface is configured to input and/or output a signal.

According to a sixth aspect, an embodiment of this application provides a communication device, including a processor and a memory. The memory is configured to store a computer program, and the processor is configured to invoke and run the computer program stored in the memory, to perform the method in the first aspect, the second aspect, or the possible implementations.

According to a seventh aspect, an embodiment of this application provides a chip, including a processor, configured to invoke computer instructions from a memory and run the computer instructions, to cause a device in which the chip is installed to perform the method in the first aspect, the second aspect, or the possible implementations.

According to an eighth aspect, an embodiment of this application provides a computer-readable storage medium, configured to store computer program instructions, and the computer program causes a computer to perform the method in the first aspect, the second aspect, or the possible implementations.

According to a ninth aspect, an embodiment of this application provides a computer program product, including computer program instructions. The computer program instructions cause a computer to perform the method in the first aspect, the second aspect, or the possible implementations.

According to a tenth aspect, an embodiment of this application provides a computer program. The computer program causes a computer to perform the method in the first aspect, the second aspect, or the possible implementations.

## BRIEF DESCRIPTION OF DRAWINGS

FIG. 1 is a diagram of an architecture of a mobile communication system to which an embodiment of this application is applied;
FIG. 2 is a diagram of a dictionary learning framework according to an embodiment of this application;
FIG. 3 is a schematic interaction flowchart of a data compression and transmission method according to an embodiment of this application;
FIG. 4a is a diagram of data division according to an embodiment of this application;
FIG. 4b is a diagram of other data division according to an embodiment of this application;
FIG. 5 is a diagram of other data division according to an embodiment of this application;
FIG. 6 is a diagram of data compression of a sparse matrix according to an embodiment of this application;
FIG. 7 is a schematic interaction flowchart of another data compression and transmission method according to an embodiment of this application;
FIG. 8 is a schematic block diagram of a communication apparatus according to an embodiment of this application; and
FIG. 9 is another schematic block diagram of a communication apparatus according to an embodiment of this application.

## DESCRIPTION OF EMBODIMENTS

The following describes technical solutions of this application with reference to accompanying drawings.

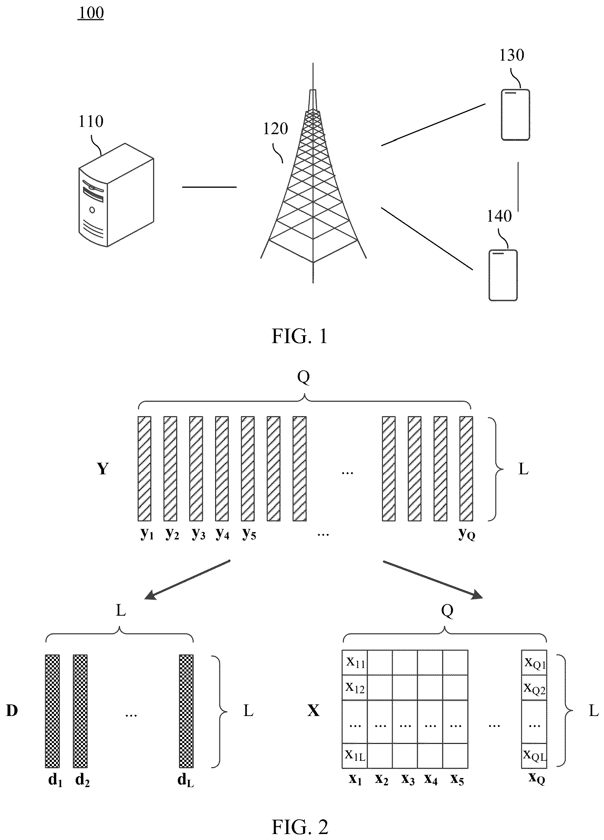

FIG. 1 is a diagram of an architecture of a mobile communication system to which an embodiment of this application is applied. As shown in FIG. 1, the mobile communication system includes a core network device 110, a network device 120, and at least one terminal device (a terminal device 130 and a terminal device 140 shown in FIG. 1). The terminal device is connected to the network device in a wireless manner, and the network device is connected to the core network device in a wireless manner or a wired manner. The core network device and the network device may be different physical devices independent of each other; functions of the core network device and logical functions of the network device may be integrated into a same physical device; or some functions of the core network device and some functions of the network device may be integrated into one physical device. The terminal device may be located at a fixed location, or may be mobile. FIG. 1 is merely a diagram. The communication system may further include another network device, for example, may further include a wireless relay device and a wireless backhaul device, which are not shown in FIG. 1. Quantities of core network devices, network devices, and terminal devices included in the mobile communication system are not limited in embodiments of this application.

In embodiments of this application, the network device may be any device with a wireless transceiver function. The network device includes but is not limited to: an evolved NodeB (evolved NodeB, eNB), a home NodeB (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), or a transmission and reception point (transmission and reception point, TRP), may be a mobile switching center, a device that undertakes functions of a base station in device-to-device (Device-to-Device, D2D), vehicle-to-everything (vehicle-to-everything, V2X), machine-to-machine (machine-to-machine, M2M) communication, and uncrewed aerial vehicle communication, and a network device (which may be deployed on a high-altitude platform, a satellite, or a high-altitude aircraft) in a non-terrestrial network (non-terrestrial network, NTN) communication system, may be a gNB in a 5G system or one or a group of antenna panels (including multiple antenna panels) of a base station in a 5G system, or may be a network node that forms a gNB or a transmission point, for example, a BBU or a distributed unit (distributed unit, DU). This is not specifically limited in embodiments of this application.

In some deployments, the gNB may include a central unit (centralized unit, CU) and a DU. The CU and the DU each implement some functions of the gNB, and the CU and the DU may communicate with each other through an F1 interface. The gNB may further include an active antenna unit (active antenna unit, AAU). The AAU may implement some physical layer processing functions, radio frequency processing, and a function related to an active antenna.

It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

In embodiments of this application, the terminal device may also be referred to as user equipment (user equipment, UE), an access terminal, a subscriber unit, a subscriber station, a mobile station, a remote station, a remote terminal, a mobile device, a user terminal, a terminal, a wireless communication device, a user agent, or a user apparatus.

The terminal device may be a device that provides voice/data connectivity for a user, for example, a handheld device or a vehicle-mounted device that has a wireless connection function. Currently, some examples of the terminal may be a mobile phone (mobile phone), a tablet computer (pad), a computer (for example, a notebook computer or a palmtop computer) with a wireless transceiver function, an uncrewed aerial vehicle, customer-premises equipment (customer-premises equipment, CPE), a point of sale (point of sale, POS) machine, a mobile internet device (mobile internet device, MID), a virtual reality (virtual reality, VR) device, an augmented reality (augmented reality, AR) device, a wireless terminal in industrial control (industrial control), a wireless terminal in self driving (self driving), a wireless terminal in telemedicine (remote medical), a wireless terminal in smart grid (smart grid), a wireless terminal in transportation safety (transportation safety), a wireless terminal in smart city (smart city), a wireless terminal in smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, a vehicle-mounted device, a wearable device, a terminal device in a 5G network, a terminal device in a system evolved after 5G, or the like.

The network device and the terminal device may communicate with each other over a licensed spectrum (licensed spectrum), or may communicate with each other over an unlicensed spectrum (unlicensed spectrum), or may communicate with each other over both a licensed spectrum and an unlicensed spectrum. The network device and the terminal device may communicate with each other on a spectrum below 6G, may communicate with each other on a spectrum above 6G, or may communicate with each other on both a spectrum below 6G and a spectrum above 6G. A spectrum resource used between the network device and the terminal device is not limited in embodiments of this application.

Specific forms of the network device and the terminal device are not limited in this application.

A communication method provided in this application may be applied to various communication systems, for example, a long term evolution (Long Term Evolution, LTE) system, a 5G mobile communication system, a 6G mobile communication system evolved after 5G. The 5G mobile communication system or the 6G mobile communication system may include non-standalone (non-standalone, NSA) networking and/or standalone (standalone, SA) networking.

A communication method provided in this application may be further applied to machine type communication (machine type communication, MTC), a long term evolution-machine technology (Long Term Evolution-machine, LTE-M), a device-to-device (device-to-device, D2D) network, a machine-to-machine (machine-to-machine, M2M) network, an internet of things (internet of things, IoT) network, or another network.

Point cloud data (point cloud data) is a set of spatial points in a three-dimensional coordinate system. For example, data is collected by using a machine vision sensor and recorded in a form of a point, and each spatial point includes three-dimensional coordinates, and may include color information (RGB), location information, reflection intensity (intensity) information, and the like. In a point cloud scenario, a terminal device (for example, 130 and/or 140 in FIG. 1) may collect data by using a sensor, and transmit the collected data to a network device (for example, 120 in FIG. 1), and the network device (for example, 120 in FIG. 1) may reconstruct point cloud data.

Federated learning (federated learning) is a distributed machine learning technology that performs distributed model training between multiple data sources that have local data, and constructs a global model based on virtual converged data by exchanging only model parameters or intermediate results without exchanging local individuals or sample data, to balance data privacy protection and data sharing and computing. A model parameter, an AI gradient, or an intermediate result transmitted in a federated learning process may be referred to as AI model data. Certainly, the AI model data is merely a possible name, and a name is not limited in this application. For example, the AI model data may also be referred to as model data or AI data. In a federated learning scenario, a terminal device (for example, 130 and/or 140 in FIG. 1) may transmit locally updated AI model data to a network device (for example, 120 in FIG. 1), to update global AI model data.

A data amount of the point cloud data and a data amount of the AI model data are large. Usually, the point cloud data may include hundreds of thousands of spatial points, and the AI model data may reach an order of magnitude of tens of millions of dimensions.

Currently, there is no effective and reliable compression and transmission solution for communication scenarios in which a large quantity of pieces of data is transmitted, for example, the point cloud scenario and the federated learning scenario. In this case, in embodiments of this application, for multiple pieces of to-be-transmitted data (for example, the following M pieces of first data, where M is an integer greater than 1), dictionary learning is performed on one piece of subdata in each piece of data based on a same dictionary matrix, to obtain a sparse representation of each piece of subdata, thereby implementing effective and reliable data compression of to-be-transmitted data with a large data amount.

In the foregoing examples, uplink transmission of the point cloud data and the AI model data is only used as an example for description, but should not be construed as any limitation on this application. For example, in the point cloud scenario, a terminal device A (for example, 130 in FIG. 1) may send point cloud data to a terminal device B (for example, 140 in FIG. 1) through forwarding by a network device (for example, 120 in FIG. 1); or a terminal device A may send point cloud data to a terminal device B through a sidelink. For another example, in the federated learning scenario, a network device (for example, 120 in FIG. 1) may transmit locally updated AI model data to a terminal device (for example, 130 and/or 140 in FIG. 1).

A data compression and transmission method provided in embodiments of this application is mainly described by using an example in which the method is applied to a communication system. However, this is not limited in this application. For example, the data compression and transmission method provided in this application may be further applied to any electronic device having a processing capability. The electronic device may be any terminal device or server. The electronic device may implement data compression based on the method provided in embodiments of this application, and output compressed data, for example, send the compressed data to another electronic device.

For ease of understanding this application, dictionary learning is first described as an example.

FIG. 2 is a diagram of a dictionary learning framework according to an embodiment of this application. As shown in FIG. 2, source data (source data) Y may be represented by a matrix with L rows multiplied by Q columns, and may also be referred to as a source matrix, and the source data Y is decomposed into a dictionary (dictionary) matrix D and a sparse matrix (sparse code) X through a numerical iteration process of dictionary learning, that is, $Y=DX$. Each element in a matrix representation of the source data Y may be a floating-point number.

The dictionary matrix D, which is also referred to as a base (base), may be a matrix with L rows multiplied by L columns, and each column in the dictionary matrix D may be referred to as a base (base) vector. The dictionary matrix D includes a feature of the source data. For example, the feature of the source data is represented through each base vector.

The sparse matrix X may represent the source data based on the dictionary matrix D. The sparse matrix X represents the feature of the source data by using a combination of base vectors in the dictionary matrix D, for example, a combination obtained by weighting each base vector in the dictionary matrix D. The sparse matrix X is a matrix with L rows multiplied by Q columns. Each column of vectors in the sparse matrix X may represent each column of vectors in the source matrix Y. For example, a first column $l_1$ of vectors in the sparse matrix X may represent $y_1$ in the source matrix.

Each row of vectors in the sparse matrix X corresponds to each base vector in the dictionary matrix D, and a value of each row in a column in the sparse matrix X represents a weight of each base vector in the dictionary matrix D. For example, the first column $x_1$ of vectors in the sparse matrix X represents $y_1$ in the source data Y, and elements in rows in the first column of vectors in the sparse matrix X are sequentially $x_{11}, x_{12}, ..., x_{1L}$. In this case, $x_{11}$ is a weight of a 1st base vector $d_1$ in the dictionary matrix used when the sparse matrix X represents the source matrix Y.

An element in the sparse matrix X may be represented or stored in a coordinate format (coordinate format), and each element may include row information, column information, and an element value of the element in the sparse matrix X. Therefore, the element in the sparse matrix X may also be referred to as coordinates (coordinate).

A larger quantity of elements whose values are 0 in the sparse matrix X indicates that less resources are occupied by information that has a low correlation with a learning task, so that storage resource overheads and transmission resource overheads are reduced while the sparse matrix X has a good capability of representing the source data Y. In this case, it is considered that sparse performance of the sparse matrix X is good.

The following describes the communication method provided in embodiments of this application with reference to the accompanying drawings.

It should be understood that, for ease of understanding and description, the following describes a method provided in embodiments of this application by using a first apparatus as an execution body. The first apparatus may be any terminal device in the communication system shown in FIG. 1, for example, the terminal device 130 or the terminal device 140, or the first apparatus may be the network device 120 in the communication system shown in FIG. 1. In some embodiments, interaction between the first apparatus and the second apparatus is used as an example to describe the method provided in embodiments of this application. When a data compression and transmission method provided in embodiments of this application is applied to uplink transmission, the first apparatus may be any terminal device in the communication system shown in FIG. 1, for example, the terminal device 130 or the terminal device 140, and a second apparatus may be the network device 120 in the communication system shown in FIG. 1. When a data compression and transmission method provided in embodiments of this application is applied to downlink transmission, the first apparatus may be the network device 120 in the communication system shown in FIG. 1, and a second apparatus may be any terminal device in the communication system shown in FIG. 1, for example, the terminal device 130 or the terminal device 140. When a data compression and transmission method provided in embodiments of this application is applied to sidelink transmission, the first communication apparatus may be any terminal device in the communication system shown in FIG. 1, for example, the terminal device 130, and a second communication apparatus may be any terminal device in the communication system shown in FIG. 1 other than the first communication apparatus, for example, the terminal device 140.

It should be further understood that this should not constitute any limitation on an execution body of the method provided in this application. Any apparatus can serve an execution body of the method provided in embodiments of this application, provided that the apparatus can perform the method provided in embodiments of this application by running a program including code of the method provided in embodiments of this application. For example, any one of the foregoing communication apparatuses may be implemented as a terminal device, or may be implemented as a component in the terminal device, for example, a chip, a chip system, or another functional module that can invoke a program and execute the program. Any one of the foregoing communication apparatuses may be implemented as a network device, or may be implemented as a component in the network device, for example, a chip, a chip system, or another functional module that can invoke a program and execute the program.

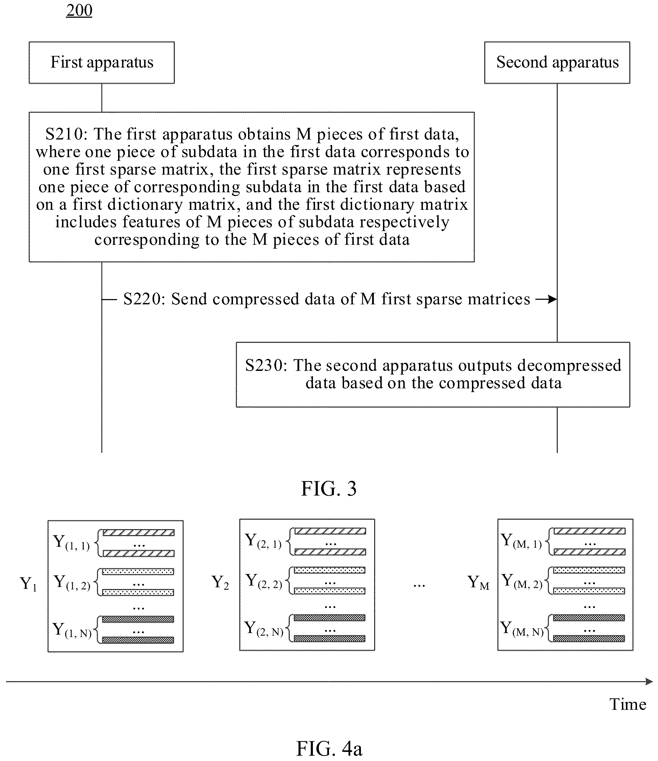

FIG. 3 is a schematic interaction flowchart of a data compression and transmission method according to an embodiment of this application. With reference to FIG. 3, a method 200 includes some or all of the following processes:

> S210: A first apparatus obtains M pieces of first data, where one piece of subdata in the first data corresponds to one first sparse matrix, the first sparse matrix represents one piece of corresponding subdata in the first data based on a first dictionary matrix, and the first dictionary matrix includes features of M pieces of subdata respectively corresponding to the M pieces of first data.
> S220: The first apparatus sends compressed data of M first sparse matrices to a second apparatus, and correspondingly, the second apparatus receives the compressed data of the M first sparse matrices that is sent by the first apparatus.
> S230: The second apparatus outputs decompressed data based on the compressed data.

The M pieces of first data may be M pieces of subdata in to-be-transmitted data. In other words, the M pieces of first data may be obtained by dividing the to-be-transmitted data. Therefore, the M pieces of first data may be similar in a time dimension and/or a spatial dimension. Certainly, this is not limited in this application. For example, the M pieces of first data may be any M pieces of data in the to-be-transmitted data.

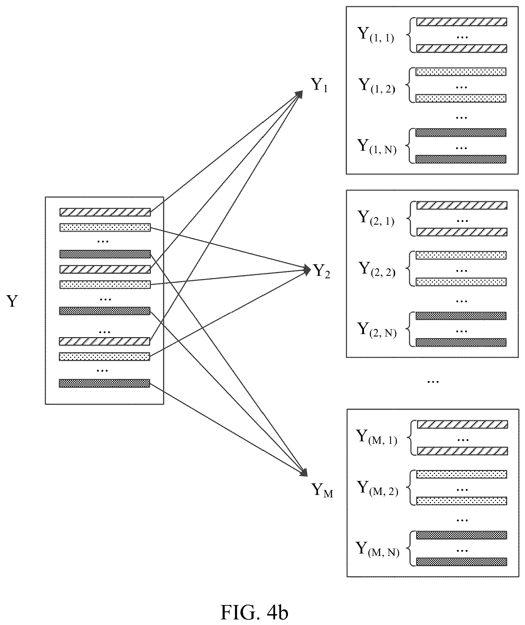

It should be noted that if the to-be-transmitted first data is used as the foregoing source data Y, and data compression is performed based on dictionary learning, when a data amount of the first data is large, the source data Y is widely distributed in space, and it is difficult to determine a dictionary matrix to obtain a sparse matrix with good sparsity. Consequently, a data processing process of obtaining a dictionary matrix D and a sparse matrix X through decomposition is complex, and a delay is long. In view of this, in this embodiment of this application, the first apparatus may split the to-be-transmitted data into the M pieces of first data, to perform dictionary learning on each piece of first data. Further, if the data amount of the first data is still large, the first data is further split to help further improve sparseness of the sparse matrix. There may be but not limited to the following two data division manners in this embodiment of this application. The following describes the two data division manners by using examples with reference to FIG. 4a and FIG. 4b.

Manner 1: Data division is performed in the time dimension.

With reference to FIG. 4a, in Manner 1, the to-be-transmitted data may include data in M time units, data in each time unit is used as one piece of first data, each time unit may include N pieces of subdata, and N is a positive integer. The time unit may be one or more data frames, one or more slots, or the like, and should not be understood as a minimum time unit. Adjacent time units in the M time units may be two consecutive time units, or may be two time units with a time interval. A time interval between two time units needs to be less than or equal to a preset time interval, to ensure a similarity between the M time units.

It should be noted that in Manner 1, the M pieces of first data each include one piece of subdata related in a spatial dimension. To be specific, a similarity between spatial locations of any two of the M pieces of subdata respectively corresponding to the M pieces of first data is greater than or equal to a first similarity threshold. For example, a similarity between a spatial location of one piece of subdata in a $p^{th}$ piece of first data and a spatial location of one piece of subdata in a $q^{th}$ piece of first data is greater than or equal to the first similarity threshold. Herein, both p and q are positive integers, and p is not equal to q. As shown in FIG. 4a, a similarity between a $1^{st}$ piece of subdata $Y_{(1, 1)}$ in a $1^{st}$ piece of first data $Y_1$ and a $1^{st}$ piece of subdata $Y_{(2, 1)}$ in a $2^{nd}$ piece of first data $Y_2$ is greater than or equal to the first similarity threshold; a similarity between the $1^{st}$ piece of subdata $Y_{(2, 1)}$ in the $2^{nd}$ piece of first data $Y_2$ and a $1^{st}$ piece of subdata $Y_{(3, 1)}$ in a $3^{rd}$ piece of first data $Y_3$ is greater than or equal to the first similarity threshold; ...; and a similarity between a $1^{st}$ piece of subdata $Y_{(M-1, 1)}$ in an $(M-1)^{th}$ piece of first data $Y_{M-1}$ and a $1^{st}$ piece of subdata $Y_{(M, 1)}$ in an $M^{th}$ piece of first data $Y_M$ is greater than or equal to the first similarity threshold. Similarly, in FIG. 4a, a similarity between a $2^{nd}$ piece of subdata $Y_{(1, 2)}$ in the $1^{st}$ piece of first data $Y_1$ and a $2^{nd}$ piece of subdata $Y_{(2, 2)}$ in the $2^{nd}$ piece of first data $Y_2$ is greater than or equal to the first similarity threshold; a similarity between the $2^{nd}$ piece of subdata $Y_{(2, 2)}$ in the $2^{nd}$ piece of first data $Y_2$ and a $2^{nd}$ piece of subdata $Y_{(3, 2)}$ in the $3^{rd}$ piece of first data $Y_3$ is greater than or equal to the first similarity threshold; ...; and a similarity between a $2^{nd}$ piece of subdata $Y_{(M-1, 2)}$ in the $(M-1)^{th}$ piece of first data $Y_{M-1}$ and a $2^{nd}$ piece of subdata $Y_{(M, 2)}$ in the $M^{th}$ piece of first data $Y_M$ is greater than or equal to the first similarity threshold. Other subdata in the first data may also have the foregoing similarity. For brevity, details are not described again. However, this is not limited in this application. For example, any first data may include at least one piece of subdata that does not have the foregoing similarity with subdata in other first data. In addition, quantities of pieces of subdata included in the M pieces of first data may be different. For ease of description, the following provides descriptions by using an example in which all $n^{th}$ pieces of subdata in the M pieces of first data are correlated. Herein, n is a positive integer less than or equal to N.

In Manner 1, for any piece (for example, an $m^{th}$ piece of first data, where m is a positive integer less than or equal to M) of the M pieces of first data, the first data may be a matrix, or the first data is represented in a form of a matrix. The first apparatus may arrange the first data in a matrix $Y_m$ with L rows multiplied by Q columns. For example, L is equal to dimensions of a spatial point, that is, L=3, and Q is equal to a total quantity of spatial points in point cloud data. For another example, the first data is AI model data, and L may be a preset value, for example, may be a value obtained through experiments that enables better sparse performance of the sparse matrix. In this case, $Q = \left\lceil \dfrac{Dim}{L} \right\rceil$. Herein, $\lceil \cdot \rceil$ represents rounding up, and $Dim$ is a gradient dimension. In this case, the first data Y needs to be padded with $LQ-Dim$ 0s.

The first apparatus may split the first data into N pieces of subdata, for example, split the first data into the N pieces of subdata based on a relationship between all pieces of data in the first data in space. Each piece of subdata may be a matrix.

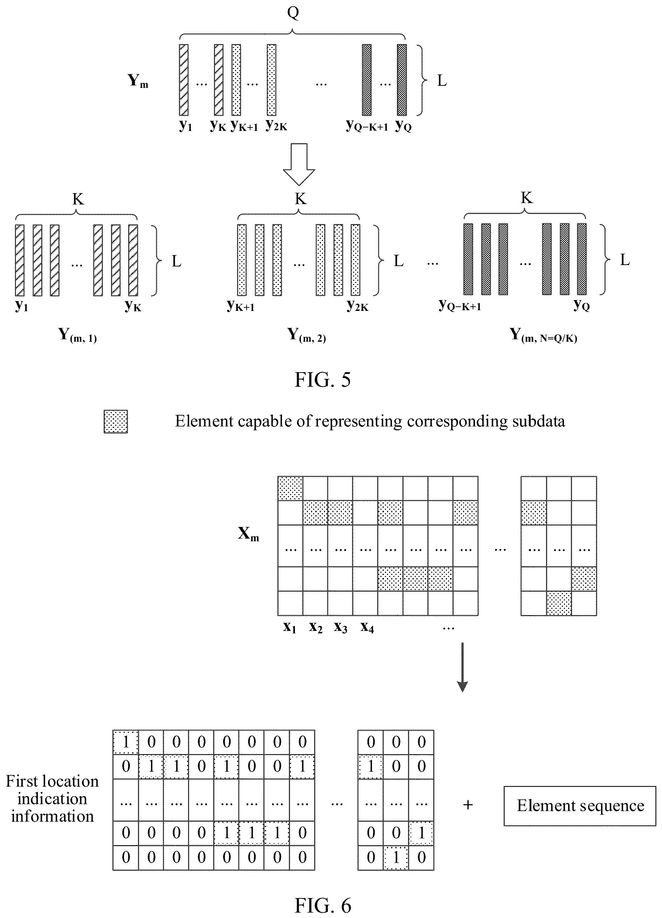

With reference to FIG. 5, Q columns (for example, $y_1$ to $y_Q$) of the $m^{th}$ piece of first data $Y_m$ may be classified into the N pieces of subdata. For example, $y_1$ to $y_k$ are classified into the $1^{st}$ piece of subdata $Y_{(m, 1)}$, $y_{K+1}$ to $y_{2K}$ are classified into the $2^{nd}$ piece of subdata $Y_{(m, 2)}$, ..., and $y_{Q-K+1}$ to $y_Q$ are classified into an $N^{th}$ piece of subdata $Y_{(m, N=Q/K)}$. FIG. 5 is described only by using an example in which quantities of columns of matrices formed by all of the N pieces of subdata are the same. However, this is not limited in this application. For example, quantities of columns of matrices of at least two pieces of subdata in the N pieces of subdata are different. When the quantities of columns of the matrices formed by all the subdata are the same, data processing complexity of the first communication apparatus and the second communication apparatus can be reduced.

For example, the first data is point cloud data. The first apparatus may divide the first data into the N pieces of subdata based on distances between all spatial points in the first data in Euclidean space. For example, P spatial points may be determined in ascending order of distances between the spatial points, P is a preset value, and the P spatial points are classified into one piece of subdata. Alternatively, spatial points in a preset range are classified into a sub-value. For example, spatial points in a circle whose center is a spatial point and whose radius is R are classified into one piece of subdata, and R is a preset value. In different first data, subdata related in the spatial dimension may be data of same or similar spatial points in Euclidean space. For example, an $n^{th}$ piece of subdata $Y_{(1, n)}$ in the $1^{st}$ piece of first data $Y_1$, an $n^{th}$ piece of subdata $Y_{(2, n)}$ in the $2^{nd}$ piece of first data $Y_2$, ..., and an $N^{th}$ piece of subdata $Y_{(M, N)}$ in the $M^{th}$ piece of first data are all data of a same spatial point (some same spatial points) in different time units.

For example, the first data is AI model data. The first apparatus may divide the first data into the M pieces of subdata based on neural network layers at which all pieces of data in the first data are located. For example, data at a same neural network layer or multiple adjacent neural network layers is classified into one piece of subdata. If a quantity of pieces of data at a same neural network layer exceeds a data amount limit of one piece of subdata, the data at the same neural network layer may be classified into two or more pieces of adjacent subdata. The neural network layer includes but is not limited to a fully connected layer, a convolutional layer, a pooling layer, and the like. In different first data, subdata related in the spatial dimension may be data at a same or similar neural network layer. For example, an $n^{th}$ piece of subdata $Y_{(1, n)}$ in the $1^{st}$ piece of first data $Y_1$, an $n^{th}$ piece of subdata $Y_{(2, n)}$ in the $2^{nd}$ piece of first data $Y_2$, ..., and an $N^{th}$ piece of subdata

$Y_{(M, N)}$ in the $M^{th}$ piece of first data are all data of a same neural network layer (or similar neural network layers) in different time units.

It should be further understood that whether subdata is similar may be determined based on a similarity of spatial locations, or may be determined based on a similarity in the time dimension. For example, if a difference between a collection time of one piece of subdata in the $p^{th}$ piece of first data and a collection time of one piece of subdata in the $q^{th}$ piece of first data is less than a preset time difference, a similarity between the two pieces of subdata is greater than or equal to the first similarity threshold. The similarity between the subdata may also be represented as that a difference is less than or equal to a preset difference threshold, and the difference between the subdata may be determined based on a residual between the subdata.

Manner 2: Data division is performed in the spatial dimension.

With reference to FIG. 4b, in Manner 2, the to-be-transmitted data may be data in h time units, h is a positive integer, and the M pieces of first data may be obtained through division by sorting the to-be-transmitted data in the h time units based on a spatial location relationship. The time unit is described in Manner 1. For brevity, details are not described again.

The to-be-transmitted data may be a matrix, or the to-be-transmitted data is represented in a form of a matrix. The first apparatus may arrange the to-be-transmitted data in a matrix Y with L rows multiplied by Q columns. Further, the first apparatus may split the to-be-transmitted data in the h time units into N' pieces of subdata. For example, the first data is split into N' pieces of subdata based on a relationship between all pieces data in the first data in space. Each piece of subdata may be a matrix. For details, refer to descriptions of the first data in Manner 1. For brevity, details are not described again.

The first apparatus may classify the N' pieces of subdata into the M pieces of first data by placing the subdata one by one in a round-robin (round-robin) manner. For example, $y_1$ in the to-be-transmitted data is placed in a $1^{st}$ piece of first data $Y_1$ and is used as a $1^{st}$ piece of subdata $Y_{(1, 1)}$ in the $1^{st}$ piece of first data $Y_1$, $y_2$ is placed in a $2^{nd}$ piece of first data $Y_2$ and is used as a $1^{st}$ piece of subdata $Y_{(2, 1)}$ in the $2^{nd}$ piece of first data $Y_2$, ..., $y_M$ is placed in the $M^{th}$ piece of first data $Y_M$ and is used as a $1^{st}$ piece of subdata $Y_{(M, 1)}$ in the $M^{th}$ piece of first data $Y_M$, $y_{M+1}$ is placed in the $1^{st}$ piece of first data $Y_1$ and is used as a $2^{nd}$ piece of subdata $Y_{(1, 2)}$ in the $1^{st}$ piece of first data $Y_1$, and so on, until all the N' pieces of subdata in the to-be-transmitted data are placed in the M pieces of first data.

Therefore, in FIG. 4b, the $1^{st}$ piece of subdata $Y_{(1, 1)}$ in the $1^{st}$ piece of first data $Y_1$, the $1^{st}$ piece of subdata $Y_{(2, 1)}$ in the $2^{nd}$ piece of first data $Y_2$, ..., and the $1^{st}$ piece of subdata $Y_{(M, 1)}$ in the $M^{th}$ piece of first data $Y_M$ are correlated in the spatial dimension. To be specific, a similarity between the $1^{st}$ piece of subdata $Y_{(1, 1)}$ in the $1^{st}$ piece of first data $Y_1$ and the $1^{st}$ piece of subdata $Y_{(2, 1)}$ in the $2^{nd}$ piece of first data $Y_2$ is greater than or equal to a first similarity threshold; a similarity between the $1^{st}$ piece of subdata $Y_{(2, 1)}$ in the $2^{nd}$ piece of first data $Y_2$ and a $1^{st}$ piece of subdata $Y_{(3, 1)}$ in a $3^{rd}$ piece of first data $Y_3$ is greater than or equal to the first similarity threshold; ...; and a similarity between a $1^{st}$ piece of subdata $Y_{(M-1, 1)}$ in the $(M-1)^{th}$ piece of first data $Y_{M-1}$ and the $1^{st}$ piece of subdata $Y_{(M, 1)}$ in the $M^{th}$ piece of first data $Y_M$ is greater than or equal to the first similarity threshold. Similarly, in FIG. 4b, a similarity between the $2^{nd}$ piece of subdata $Y_{(1, 2)}$ in the $1^{st}$ piece of first data $Y_1$ and a $2^{nd}$ piece of subdata $Y_{(2, 2)}$ in the $2^{nd}$ piece of first data $Y_2$ is greater than or equal to the first similarity threshold; a similarity between the $2^{nd}$ piece of subdata $Y_{(2, 2)}$ in the $2^{nd}$ piece of first data $Y_2$ and a $2^{nd}$ piece of subdata $Y_{(3, 2)}$ in a $3^{rd}$ piece of first data $Y_3$ is greater than or equal to the first similarity threshold; ...; and a similarity between a $2^{nd}$ piece of subdata $Y_{(M-1, 2)}$ in the $(M-1)^{th}$ piece of first data $Y_{M-1}$ and a $2^{nd}$ piece of subdata $Y_{(M, 2)}$ in the $M^{th}$ piece of first data $Y_M$ is greater than or equal to the first similarity threshold. Other subdata in the first data may also have the foregoing similarity. For brevity, details are not described again. However, this is not limited in this application. For example, any first data may include at least one piece of subdata, and the at least one piece of subdata does not have the foregoing similarity with subdata in other first data.

Data Y in FIG. 4b is data in the h time units, for example, data in one time unit, data in two time units, or data in more time units.

In both Manner 1 and Manner 2, only an example in which a similarity between subdata (for example, the $1^{st}$ piece of subdata in the first data) at a same location in all first data is greater than or equal to the first similarity threshold is used for description. However, this is not limited in this application. For example, a similarity between the $2^{nd}$ piece of subdata in the $1^{st}$ piece of first data and a $4^{th}$ piece of subdata in the $2^{nd}$ piece of first data is greater than or equal to the first similarity threshold. In addition, a similarity between subdata may not be limited to a similarity between adjacent first data, and may be a similarity between any two of the M pieces of first data. For example, the similarity between one piece of subdata in the $p^{th}$ piece of first data and one piece of subdata in the $q^{th}$ piece of first data is greater than or equal to the first similarity threshold. Herein, both p and q are positive integers, and p is not equal to q. For example, a similarity between subdata in the $1^{st}$ piece of first data and subdata in the $3^{rd}$ piece of first data may be greater than or equal to the first similarity threshold.

In both Manner 1 and Manner 2, an example in which there is one piece of similar subdata in each piece of different first data is used for description. A quantity of pieces of similar subdata in each piece of first data is not limited in this application. For example, a similarity between a $1^{st}$ piece of subdata in the $q^{th}$ piece of first data and each of a $1^{st}$ piece of

subdata and a 2nd piece of subdata in the $p^{th}$ piece of first data is greater than or equal to the first similarity threshold. In other words, the 1st piece of subdata and the 2nd piece of subdata in the $p^{th}$ piece of first data share the first dictionary matrix with the 1st piece of subdata in the $q^{th}$ piece of first data. For another example, a similarity between each of a 1st piece of subdata and a 3rd piece of subdata in the $p^{th}$ piece of first data and each of a 1st piece of subdata and a 2nd piece of subdata in the $q^{th}$ piece of first data is greater than or equal to the first similarity threshold. In other words, the 1st piece of subdata and the 3rd piece of subdata in the $p^{th}$ piece of first data share the first dictionary matrix with the 1st piece of subdata and the 2nd piece of subdata in the $q^{th}$ piece of first data.

To improve a compression rate, in this embodiment of this application, one piece of subdata in each of the M pieces of first data shares the first dictionary matrix. In other words, the first dictionary matrix includes the features of the M pieces of subdata respectively corresponding to the M pieces of first data. The M pieces of subdata may be subdata related in the spatial dimension in the foregoing example. For example, the M pieces of subdata may include the $n^{th}$ piece of subdata $Y_{(1, n)}$ in the 1st piece of first data $Y_1$, the $n^{th}$ piece of subdata $Y_{(2, n)}$ in the 2nd piece of first data $Y_2$, ..., and the $n^{th}$ piece of subdata $Y_{(M, n)}$ in the $M^{th}$ piece of first data $Y_M$.

When the M pieces of subdata share the first dictionary matrix, for each of the M pieces of subdata, the first apparatus performs dictionary learning on the subdata based on the first dictionary matrix, to obtain a first sparse matrix corresponding to the subdata. The first sparse matrix performs a sparse representation on the subdata based on the first dictionary matrix.

It should be understood that each piece of first data may include at least one piece of subdata correlated with subdata in other first data. When each piece of first data includes multiple pieces of subdata separately correlated with subdata in other first data, the M pieces of first data may correspond to multiple groups of subdata, each group of subdata includes M pieces of subdata, and the M pieces of subdata in each group of subdata are correlated with each other. In other words, the M pieces of subdata in each group of subdata share one first dictionary matrix. For example, the $n^{th}$ piece of subdata $Y_{(1, n)}$ in the 1st piece of first data $Y_1$, the $n^{th}$ piece of subdata $Y_{(2, n)}$ in the 2nd piece of first data $Y_2$, ..., the $n^{th}$ piece of subdata $Y_{(M, n)}$ in the $M^{th}$ piece of first data $Y_M$ may be one group of subdata. For ease of description, one group of subdata corresponding to the M pieces of first data is only used as an example for description in this embodiment of this application. Some subdata in the first data may not share a dictionary matrix with subdata in other first data. Such subdata may be decomposed into a second dictionary matrix and a second sparse matrix based on dictionary learning, and compression and transmission are performed. It should be understood that, in this application, for ease of understanding, the M pieces of correlated subdata are represented as one group of subdata instead of an actual data set, and the subdata in the first data is not actually grouped.

The first dictionary matrix may be a preconfigured fixed dictionary matrix, for example, may be configured by the second apparatus for the first apparatus, or may be configured by the first apparatus for the second apparatus; or the first dictionary matrix may be generated or updated by the first apparatus. In this case, the first apparatus may send the first dictionary matrix to the second apparatus.

For example, the first dictionary matrix may be obtained through decomposition after the first apparatus performs dictionary learning on a $k^{th}$ piece of subdata in the M pieces of subdata. For example, the first apparatus decomposes the $k^{th}$ piece of subdata based on dictionary learning, to obtain the first dictionary matrix and a first sparse matrix corresponding to the $k^{th}$ piece of subdata. To improve data processing convenience, the first apparatus may decompose a 1st piece of subdata in the M pieces of subdata, to obtain the first dictionary matrix and a first sparse matrix corresponding to the 1st piece of subdata. The $k^{th}$ piece of subdata may be one piece of subdata in a $k^{th}$ piece of first data $Y_k$.

Still in the foregoing example, for M-1 pieces of subdata other than the $k^{th}$ piece of subdata in the M pieces of subdata, the first apparatus may determine a first sparse matrix corresponding to each piece of the M-1 pieces of subdata based on the first dictionary matrix. Further, the M first sparse matrices are obtained.

It should be understood that a sparse matrix with good sparse performance has a large quantity of elements whose values are 0, to implement compression of the first data to some extent. In this embodiment of this application, the first apparatus may perform data compression on some or all the M first sparse matrices, to further improve compression performance. For example, with reference to FIG. 6, the first apparatus may convert a first sparse matrix $X_m$ into first location indication information and an element sequence. The first location indication information indicates a location of an element, in the sparse matrix, capable of representing corresponding subdata. The first apparatus sets, to a first value based on an indication of the first location indication information, a value of a first element that is in the first sparse matrix and that is incapable of representing corresponding subdata. The element sequence includes an element that is capable of representing corresponding subdata, that is, an element that is not set to the first value. The first value may be zero, or may be any other value. With reference to FIG. 6, in the first sparse matrix, an element in a first row in a column $x_1$, an element in a second row in a column $x_2$, an element in a second row in a column $x_3$, and the like are capable of representing corresponding subdata. In this case, the element sequence includes the elements in the sparse matrix that are capable of representing the subdata such as the element in the first row in the column $x_1$, the element in the second row in the column $x_2$, and the element in the second row in the column $x_3$. For example, in the sparse matrix, a value of the element in the first row in the column $x_1$ is 0.1, a value of the element in the second row in the column $x_2$ is -0.5, a value of the element in the second row in the column $x_3$ is 0.8, .... These elements are capable of representing the subdata. The element sequence may be represented as [0.1, -0.5, 0.8, ...]. However, an absolute value of a value of an element at another location other than the elements at the foregoing locations in the sparse matrix $X_i$ is small (including an element whose value is 0 or whose difference between a value and 0 is less than a preset capability threshold). The element at such a location is incapable of representing the subdata. For example, in the first sparse matrix, a value of an element in a second row in the column $x_1$ is -0.005, and a value of an element in a first row in the column $x_2$ is 0.0002. The first location indication information indicates the locations of the elements capable of representing the subdata in the first sparse matrix. In other words, the first location indication information indicates locations at which elements are capable of representing the corresponding subdata in the first sparse matrix. The first location indication information and the element sequence may be used as compressed data of the first sparse matrix.

The first location indication information may include a tree structure, a bitmap, a location index, and the like. This is not limited in this application. For example, the first location indication information is a bitmap. With reference to FIG. 6, bits in the bitmap are in one-to-one correspondence with elements in the first sparse matrix, and a bit in the bitmap indicates whether a corresponding element in the first sparse matrix is capable of representing corresponding subdata. For example, when the bit in the bitmap is 1, it indicates that a corresponding element in the first sparse matrix is capable of representing corresponding subdata; or when the bit in the bitmap is 0, it indicates that a corresponding element in the first sparse matrix is incapable of representing corresponding subdata. For another example, when the bit in the bitmap is 0, it indicates that a corresponding element in the first sparse matrix is capable of representing corresponding subdata; or when the bit in the bitmap is 1, it indicates that a corresponding element in the first sparse matrix is incapable of representing corresponding subdata.

The first location indication information may include at least one location index, and each location index may indicate a location, in the first sparse matrix, of an element that is in the first sparse matrix and that is capable of representing corresponding subdata. For example, the location index indicates that an element that is in the first sparse matrix and that is capable of representing corresponding subdata is in a second row and a fifth column.

When the first location indication information includes the tree structure, a basic tree structure corresponding to the first sparse matrix may be constructed, and some or all subnodes in the basic tree structure are in one-to-one correspondence with in the first sparse matrix. For example, in a process of constructing the basic tree structure, multi-level interval division may be performed on a basic two-dimensional plane, each interval is used as a subnode of the basic tree structure, and a quantity of minimum intervals (namely, subnodes at a lowest layer in the basic tree structure) obtained through division is greater than or equal to a quantity of elements in the first sparse matrix. A size of the basic two-dimensional plane is not limited in this application. For example, in the process of constructing the basic tree structure, the basic tree structure is equally divided into four intervals by using two straight lines that are perpendicular to each other, and the four intervals respectively correspond to four subnodes of a root node in the basic tree structure. For each of the four intervals, when the interval includes an element that is capable of representing corresponding subdata, a value of the subnode is a second value; or when the interval does not include an element that is capable of representing corresponding subdata, a value of the subnode is a third value. Further, the interval is divided into four subintervals by using two straight lines that are perpendicular to each other, and the four subintervals respectively correspond to four subnodes at a lower level of the subnode corresponding to the interval in the basic tree structure. Similarly, when a subinterval includes an element that is capable of representing corresponding subdata, a value of a subnode corresponding to the subinterval in the basic tree structure is the second value; or when a subinterval does not include an element that is capable of representing corresponding subdata, a value of a subnode corresponding to the subinterval in the basic tree structure is the third value. The rest can be deduced by analogy, and construction of the tree structure ends until the minimum interval is obtained. The second value may be 1, and the third value may be 0; or the second value may be 0, and the third value may be 1; or the second value and the third value may be any two different values. This is not limited in this application.

For example, a size of a first sparse matrix of point cloud data is $3 \times 16$. In a process of constructing a basic tree structure, the basic tree structure is equally divided into four intervals by using two straight lines perpendicular to each other, the four intervals respectively correspond to four subnodes of a root node in the tree structure, each interval is then equally divided into four subintervals corresponding to four subnodes at a lower level of a subnode corresponding to the interval in the basic tree structure. The rest may be deduced by analogy, $16 \times 16$ minimum intervals are obtained through four times of interval division (or four times of recursion), and the basic tree structure of the first sparse matrix is constructed. Some subnodes in the basic tree structure may be in one-to-one correspondence with elements in the first sparse matrix. For example, subnodes that are in the basic tree structure and that respectively correspond to $3 \times 16$ minimum intervals in an upper left corner of a basic two-dimensional plane indicate $3 \times 16$ elements in the first sparse matrix. Optionally, the first location indication information may be the basic tree structure, and values of nodes that are in the basic tree structure and that correspond to intervals that are in the basic tree structure and that do not include elements in the first sparse matrix are all third values. Alternatively, a tree structure in the first location indication information may include some subnodes in the basic tree structure, and the some subnodes are subnodes corresponding to intervals that are in the basic two-dimensional plane and that include elements in the first sparse matrix.

In the foregoing examples, the minimum interval obtained through division includes one element in the first sparse matrix. A case in which the minimum interval includes multiple elements in the first sparse matrix or multiple minimum intervals correspond to one element in the first sparse matrix is not excluded in this application. When the minimum interval includes one element, a location indicated by the first location indication information is more accurate, so that data constructed by the second communication apparatus based on the first location indication information is more accurate. When the minimum interval includes multiple elements, the first location indication information occupies fewer transmission resources, thereby reducing resource overheads.

The foregoing example description of the first location indication information may be applicable to the description of the location indication information in the following related embodiments. Implementations thereof are the same or similar. For brevity, details are not described again.

When the first apparatus is implemented as a chip or a chip system, S220 may be replaced with that the first apparatus outputs the compressed data of the M first sparse matrices, and sends the compressed data of the M first sparse matrices by using a terminal device or a network device in which the first apparatus is deployed.

As described above, the M pieces of first data may correspond to multiple groups of subdata, and each group of subdata is represented by corresponding M first sparse matrices based on a same first dictionary matrix. The first apparatus may send compressed data of first sparse matrices corresponding to all the multiple groups of subdata together after performing protocol encapsulation; or the first apparatus may send compressed data of the M first sparse matrices corresponding to one group of subdata together after performing encapsulation; or the first apparatus may separately send compressed data of each first sparse matrix after performing encapsulation.

The first apparatus may further send the first dictionary matrix to the second apparatus. Optionally, when the first apparatus is implemented as a chip or a chip system, the first apparatus outputs the first dictionary matrix, and the terminal device or the network device in which the first apparatus is deployed sends the first dictionary matrix.

After receiving the compressed data that is of the M first sparse matrices and that is sent by the first apparatus, the second apparatus may decompress the compressed data of the M first sparse matrices, to obtain the decompressed data. It should be noted that, decompressing the M first sparse matrices may alternatively be represented as recovering the M first sparse matrices or constructing the M first sparse matrices, and a meaning represented after a word order is changed for ease of description is still consistent. For example, data recovery is performed on the M first sparse matrices, or data construction is performed on the M first sparse matrices.

The second apparatus may construct the M first sparse matrices based on the first dictionary matrix and the compressed data.

In some embodiments, the first apparatus may perform compression processing on the first dictionary matrix and/or the compressed data of the M first sparse matrices. The compression processing includes but is not limited to quantization (for example, scalar quantization or vector quantization) and/or entropy encoding. Correspondingly, the second apparatus receives the first dictionary matrix and/or compressed data of the M first sparse matrices that are/is obtained through compression processing, and needs to perform corresponding decompression processing on the first dictionary matrix and/or compressed data of the M first sparse matrices that are/is obtained through compression processing.

Therefore, in this embodiment of this application, dictionary learning is performed on the M pieces of subdata respectively corresponding to the M pieces of first data based on one first dictionary matrix, to obtain a sparse representation of each piece of subdata, to implement effective and reliable data compression and transmission in a transmission scenario with a large data amount.

To further improve the compression rate, in this embodiment of this application, joint compression may be performed on the M first sparse matrices. The following two implementations are used as examples for description.

Implementation 1: Perform joint compression on the M first sparse matrices through low-rank approximation.

During Implementation 1, the first apparatus may determine a first matrix based on the M first sparse matrices, and perform low-rank approximation on the first matrix, to obtain first compressed data of the M first sparse matrices. A manner of obtaining the M first sparse matrices is described in the foregoing example. Details are not described herein again.

In a first example of Implementation 1, the first apparatus may combine the M first sparse matrices, to obtain the first matrix. For example, the M first sparse matrices ($X_1$ to $X_M$) may be stacked by row, to obtain a first matrix

$$X = \begin{bmatrix} X_1 \\ X_2 \\ \cdots \\ X_M \end{bmatrix}$$

; or the M first sparse matrices ($X_1$ to $X_M$) may be stacked by column, to obtain the first matrix $X = [X_1, X_2 \cdots X_M]$.

In a second example of Implementation 1, the first apparatus may first perform data compression on at least one of the M first sparse matrices, and combine M first sparse matrices obtained through data compression, to obtain the first matrix.

Still in the second example, an $m^{th}$ first sparse matrix $X_m$ is used as an example, and a first sparse matrix obtained through data compression is $\tilde{X}_m = [X_m \odot B_m]$. $B_m$ is first location indication information corresponding to the $m^{th}$ first sparse matrix. To be specific, a value of a first element in the $m^{th}$ first sparse matrix is set to a first value based on the first location indication information $B_m$, to implement data compression. The first sparse matrix obtained through data compression may be understood as an element sequence including an element that is in the first sparse matrix and that is capable of representing corresponding subdata. Optionally, performing data compression on the first sparse matrix $X_m$ may further include: performing quantization (including scalar quantization or vector quantization) on the first sparse matrix $\tilde{X}_m$ after the compressed first sparse matrix $\tilde{X}_m$ is obtained. The first location indication information and the first element are described in the foregoing example. Details are not described herein again. It should be further noted that the first apparatus may perform the foregoing data compression on one or more of the M first sparse matrices.

When performing the foregoing data compression on multiple first sparse matrices in the M first sparse matrices, the first apparatus may perform data compression on the multiple first sparse matrices based on same first location indication information (namely, $B_1 = B_2 = \cdots = B_M$). To be specific, the first apparatus sets a value of a first element in each first sparse matrix to the first value based on the same first location indication information. In this case, the first location indication information may be determined based on one of the M first sparse matrices. The one sparse matrix may be a first sparse matrix corresponding to a $1^{st}$ piece of subdata in the M first sparse matrices, or may be any first sparse matrix in the M first sparse matrices. For example, the first apparatus determines first location indication information and an element sequence corresponding to the one first sparse matrix. Further, when performing data compression on M-1 sparse matrices other than the one first sparse matrix, the first apparatus may select, based on the first location indication information, an element that is in each first sparse matrix and that is capable of representing corresponding subdata, that is, set, to the first value, a value of an element that is incapable of representing corresponding subdata, to obtain an element sequence of each first sparse matrix.

When performing the foregoing data compression on the multiple first sparse matrices in the M first sparse matrices, the first apparatus may determine first location indication information corresponding to each of the multiple first sparse matrices, and then, for each of the multiple first sparse matrices, perform data compression on the first sparse matrix based on the first location indication information corresponding to the first sparse matrix.

Optionally, the first apparatus may determine the first location indication information based on a result of comparing a capability threshold and each element in the first sparse matrix. For example, a bit 1 in the first location indication information indicates a location of an element whose absolute value is greater than the capability threshold, namely, an element that is capable of representing corresponding subdata, and a bit 0 in the first location indication information indicates a location of an element whose absolute value is less than the capability threshold, namely, an element that is incapable of representing corresponding subdata. An element whose absolute value is equal to the capability threshold may be determined as an element that is capable of representing corresponding subdata or an element that is incapable of representing corresponding subdata. This is not limited in this application. The first apparatus may further determine the first location indication information based on first W elements with largest absolute values in the first sparse matrix. For example, the first apparatus determines the first W elements with largest absolute values in the first sparse matrix as elements capable of representing corresponding subdata, and determines an element other than the W elements in the first sparse matrix as an element that is incapable of representing corresponding subdata. Further, the bit 1 in the first location indication information indicates a location of the element that is capable of representing corresponding subdata, and the bit 0 indicates a location of the element that is incapable of representing corresponding subdata. It should be understood that a bit value that indicates the location of the element that has or is incapable of representing corresponding subdata is not limited in this application. For example, the bit 1 may further indicate the location of the element that is incapable of representing corresponding subdata, and the bit 0 may indicate the location of the element that is capable of representing corresponding subdata.

Still in the second example, the first apparatus may combine the first sparse matrix obtained through data compression, for example, an element sequence of a first sparse matrix obtained after element selection is performed based on a representation capability, to obtain the first matrix. For example, the M first sparse matrices ($\tilde{X}_1$ to $\tilde{X}_M$) obtained through data compression may be stacked by row, to obtain a first matrix $\tilde{X} = \begin{bmatrix} \tilde{X}_1 \\ \tilde{X}_2 \\ \cdots \\ \tilde{X}_M \end{bmatrix}$; or the M first sparse matrices ($\tilde{X}_1$

to $\tilde{X}_M$) obtained through data compression may be stacked by column, to obtain a first matrix $\tilde{X} = [\tilde{X}_1, \tilde{X}_2 \cdots \tilde{X}_M]$.

In both the first example and the second example of Implementation 1, the first matrix is a high-dimensional matrix, and direct transmission of the first matrix causes high communication overheads. Therefore, the first apparatus may perform singular value decomposition on the first matrix, to obtain K feature values (or referred to as singular values) and feature vectors (or referred to as singular value vectors) respectively corresponding to the K feature values. The K feature values and the feature vectors respectively corresponding to the K feature values may represent the first matrix. For example, the first matrix $\tilde{X}$ is converted into $USV^T$ after singular value decomposition. Herein, $U$ is a left singular matrix, S is a singular matrix, and $V^T$ is a right singular matrix. The left singular matrix may include K columns, the singular matrix may include K singular values, and the right singular matrix may include K rows. Further, the first apparatus uses $K_0$ feature values in the K feature values and feature vectors (including $K_0$ column vectors of the left singular matrix and $K_0$ row vectors of the right singular matrix) respectively corresponding to the $K_0$ feature values as the first compressed data of the M first sparse matrices. A low-rank approximation process may be represented as $\tilde{X} = USV^T \approx U_{:,1:K_0} S_{K_0} V^T_{1:K_0,:}$. Herein, $U_{:,1:K_0}$ represents elements in all rows in a $1^{st}$ column to a $K_0^{th}$ column of the left singular matrix, $S_{K_0}$ represents first $K_0$ feature values of the singular matrix, and $V^T_{1:K_0,:}$ represents elements in all columns in a $1^{st}$ row to a $K_0^{th}$ row of the right singular matrix. It may be understood that an earlier singular value in the singular matrix has a stronger representation capability for the first matrix, and correspondingly, an earlier column vector in the left singular matrix has a stronger representation capability for the first matrix, and an earlier row vector in the right singular matrix has a stronger representation capability for the first matrix. Therefore, the first matrix is represented by using the first $K_0$ feature values and feature vectors respectively corresponding to the $K_0$ feature values, to implement low-rank approximation of the first matrix, and further implement low-rank approximation of the M pieces of first data.

As described above, the M pieces of first data may correspond to the multiple groups of subdata, each group of subdata is represented by using the corresponding M first sparse matrices based on the same first dictionary matrix, and one piece of first compressed data is formed based on the M first sparse matrices that represent the corresponding subdata based on the same first dictionary matrix. The first apparatus may send first compressed data respectively corresponding to the multiple groups of subdata together after performing protocol encapsulation, or the first apparatus may separately send each piece of first compressed data after performing protocol encapsulation.

In some embodiments, the first apparatus transmits compressed data of the M pieces of first data in an incremental manner. In this case, the first compressed data may be the compressed data of the M pieces of first data transmitted in an initial transmission process. In an incremental transmission process, the first apparatus may send second compressed data of the M first sparse matrices to the second apparatus. The second compressed data may include $K_1$ feature values other than the $K_0$ feature values in the K feature values obtained through singular value decomposition, and feature vectors respectively corresponding to the $K_1$ feature values. The $K_0$ feature values may be first $K_0$ feature values in the K feature values, and the $K_1$ feature values may be first $K_1$ feature values other than the first $K_0$ feature values in the K feature values, for example, a $(K_0+1)^{th}$ feature value to a $(K_0+K_1)^{th}$ feature value. Correspondingly, the feature vectors respectively corresponding to the $K_1$ feature values may include $(K_0+1)^{th}$ to $(K_0+K_1)^{th}$ column vectors of the left singular matrix and $(K_0+1)^{th}$ to $(K_0+K_1)^{th}$ row vectors of the right singular matrix.

It may be understood that the first apparatus may incrementally transmit one or more of the multiple groups of subdata. When incrementally transmitting at least two groups of subdata, the first apparatus may send second compressed data respectively corresponding to the multiple groups of subdata together after performing protocol encapsulation, or the first apparatus may separately send each piece of second compressed data after performing protocol encapsulation.

It should be further understood that the first apparatus may perform one or more incremental transmissions. For example, during a second incremental transmission, the first apparatus may send third compressed data to the second apparatus. The third compressed data may include $K_2$ feature values other than the $K_0+K_1$ feature values in the K feature values, and feature vectors respectively corresponding to the $K_2$ feature values.

When the first apparatus is implemented as a chip or a chip system, the first apparatus may output the second compressed data, and send the second compressed data by using a terminal device or a network device in which the first apparatus is deployed and by using a transceiver.

Implementation 2: Perform joint compression on the M first sparse matrices in a residual-based manner.

During Implementation 2, the first apparatus may sequentially send the compressed data of all the M first sparse matrices, and each time compressed data of a first sparse matrix is sent, currently sent compressed data of a first sparse matrix may be determined based on previously sent compressed data of a first sparse matrix. For ease of description, that a $j^{th}$ first sparse matrix in the M first sparse matrices is currently sent is used as an example. The first apparatus determines first residual information based on information about the $j^{th}$ first sparse matrix and information about an $i^{th}$ first sparse matrix, and sends the first residual information to the second apparatus by using the first residual information as compressed data of the $j^{th}$ first sparse matrix. Herein, i is less than j, and both i and j are positive integers. The information about the i^th first sparse matrix may be obtained by decompressing compressed data of the i^th first sparse matrix.

In some embodiments, any one of the M first sparse matrices is used as a basic sparse matrix. The first apparatus may use first location indication information and an element sequence of the basic sparse matrix as compressed data of the basic sparse matrix, and for each of M-1 first sparse matrices other than the basic sparse matrix, the first apparatus performs compression and transmission on each first sparse matrix based on a manner of performing compression and transmission on the j^th first sparse matrix. The basic sparse matrix may be a first sparse matrix that is compressed and transmitted at a first time in the M first sparse matrices.

In some other embodiments, the M first sparse matrices are grouped into multiple sparse matrix groups, and any first sparse matrix in each sparse matrix group is used as a basic sparse matrix in the group. The first apparatus may use first location indication information and an element sequence of the basic sparse matrix as compressed data of the basic sparse matrix, and for a first sparse matrix other than the basic sparse matrix in the group, the first apparatus performs compression and transmission on each first sparse matrix in the group based on a manner of performing compression and transmission on the j^th first sparse matrix. The basic sparse matrix may be a first sparse matrix that is compressed and transmitted at a first time in the sparse matrix group.

For example, the first apparatus may determine a residual matrix based on the information about the j^th first sparse matrix and the information about the i^th first sparse matrix, and then determine the first residual information based on the residual matrix. The first residual information may include a first residual element sequence, the first residual element sequence includes a residual element whose absolute value is greater than or equal to a first residual threshold in the residual matrix, and an element whose absolute value is greater than or equal to the first residual threshold and is capable of representing a residual between the information about the j^th first sparse matrix and the information about the i^th first sparse matrix. The second apparatus may construct the j^th first sparse matrix based on the first residual element sequence and the information about the i^th first sparse matrix. Optionally, when a residual matrix between the j^th first sparse matrix and a matrix obtained by decompressing the compressed data of the i^th first sparse matrix is obtained, a difference between values of elements at each corresponding location in the two matrices may be calculated, to obtain the residual matrix.

Still in the foregoing example, the first residual information may further include second location indication information. The second location indication information indicates a location of a residual element whose absolute value is greater than the first residual threshold in the residual matrix between the information about the j^th first sparse matrix and the information about the i^th first sparse matrix, that is, indicates a location of an element that is in the residual matrix and that is capable of representing the residual between the information about the j^th first sparse matrix and the information about the i^th first sparse matrix. It should be noted that, the second location indication information may further indicate the location of a residual element whose absolute value is greater than the first residual threshold in the residual matrix, namely, a location of an element that is in the residual matrix and that is incapable of representing the residual between the information about the j^th first sparse matrix and the information about the i^th first sparse matrix. An element whose absolute value is equal to the first residual threshold in the residual matrix may be considered to be capable of representing the residual incapable of representing the residual. This is not limited in this application. Bits indicating two residual elements that are capable or incapable of representing the residual between the information about the j^th first sparse matrix and the information about the i^th first sparse matrix may be different.

For example, the first apparatus may obtain the residual matrix based on a difference between the j^th first sparse matrix and the recovered i^th first sparse matrix; or the first apparatus may obtain the residual matrix based on a difference between a j^th first sparse matrix (for example, $\bar{X}_j = [X_j \odot B_j]$) obtained through data compression and a recovered i^th first sparse matrix $\tilde{X}_i{}'$ (for example, $\tilde{X}_i{}' \approx \tilde{X}_i = \left[ X_i \odot B_i \right]$, where $\bar{X}_j$ represents the i^th first sparse matrix obtained through data compression, and $\tilde{X}_i{}'$ represents the recovered i^th first sparse matrix) obtained through data compression.

To further improve a compression rate of the M first sparse matrices, in some embodiments of Implementation 2, the first apparatus may determine a similarity between the j^th first sparse matrix and the i^th first sparse matrix. When the similarity between the j^th first sparse matrix and the i^th first sparse matrix is less than a second similarity threshold, the first apparatus sends the first residual information to the second apparatus; when the similarity between the j^th first sparse matrix and the i^th first sparse matrix is greater than or equal to the second similarity threshold, the first apparatus does not send the compressed data of the j^th first sparse matrix; when the similarity between the j^th first sparse matrix and the i^th first sparse matrix is equal to the second similarity threshold, the compressed data of the j^th first sparse matrix may be sent or not sent. This is not limited in this application.

When the first apparatus does not send the compressed data of the j^th first sparse matrix, the second apparatus uses the compressed data of the i^th first sparse matrix as the compressed data of the j^th first sparse matrix. In other words, the second apparatus uses the constructed i^th first sparse matrix as the j^th first sparse matrix.

The similarity between the j^th first sparse matrix and the i^th first sparse matrix may be determined based on the residual matrix between the j^th first sparse matrix and the i^th first sparse matrix. For example, the similarity between the j^th

first sparse matrix and the $i^{th}$ first sparse matrix is determined based on a modulus value (for example, $\|X_j - X_i\|$ or $\|X_j \odot B_j - X_i \odot B_i\|$) of the residual matrix. A larger modulus value of the residual matrix indicates a lower similarity between the $j^{th}$ first sparse matrix and the $i^{th}$ first sparse matrix. For another example, the similarity between the $j^{th}$ first sparse matrix and the $i^{th}$ first sparse matrix may be determined based on a ratio of the modulus value of the residual matrix to a first modulus value. The first modulus value may be a modulus value of the $i^{th}$ first sparse matrix (for example, $\|X_i\|$ or $\|X_i \odot B_i\|$), or a modulus value of the $j^{th}$ first sparse matrix (for example, $\|X_j\|$ or $\|X_j \odot B_j\|$), and a larger ratio of the modulus value of the residual matrix to the first modulus value indicates a lower similarity between the $j^{th}$ first sparse matrix and the $i^{th}$ first sparse matrix.

It should be understood that, before sending the compressed data of the $j^{th}$ first sparse matrix to the second apparatus, the first apparatus may send compressed data of at least one first sparse matrix to the second apparatus. In this case, the $i^{th}$ first sparse matrix may be any one of the at least one first sparse matrix. To facilitate compression and transmission and data recovery, the $i^{th}$ first sparse matrix may be a first sparse matrix that is in the at least one first sparse matrix and that is transmitted in one transmission closest to the $j^{th}$ first sparse matrix. When the $i^{th}$ first sparse matrix is a $1^{st}$ first sparse matrix, during Implementation 2, the compressed data of the $i^{th}$ first sparse matrix includes first location indication information and an element sequence of the $i^{th}$ first sparse matrix; and when the $i^{th}$ first sparse matrix is not the $1^{st}$ first sparse matrix, during Implementation 2, the compressed data of the $i^{th}$ first sparse matrix includes second location indication information and a first residual element sequence of the $i^{th}$ first sparse matrix.

As described above, the M pieces of first data may correspond to the multiple groups of subdata, and each group of subdata is represented by using the corresponding M first sparse matrices based on the same first dictionary matrix. Compression information of first sparse matrices respectively corresponding to data in each group may be sent together after protocol encapsulation is performed. For example, the $n^{th}$ piece of subdata $Y_{(1, n)}$ in the first data $Y_1$, the $n^{th}$ piece of subdata $Y_{(2, n)}$ in the $2^{nd}$ piece of first data $Y_2$, ..., and the $n^{th}$ piece of subdata $Y_{(M, n)}$ in the $M^{th}$ piece of first data $Y_M$ may be sent together after protocol encapsulation is performed, or compressed data of first sparse matrices respectively corresponding to data in each group may be separately sent after protocol encapsulation is performed.

When the first apparatus is implemented as a chip or a chip system, the first apparatus may output the compressed data of the M first sparse matrices, and send the second compressed data by using a terminal device or a network device in which the first apparatus is deployed and by using a transceiver.

In some embodiments, the first apparatus transmits the compressed data of the M pieces of first data in an incremental manner. In this case, the first residual information sent in the foregoing embodiment may be the compressed data of the $j^{th}$ first sparse matrix transmitted in the initial transmission process. In the incremental transmission process, the first apparatus may send second residual information of the $j^{th}$ first sparse matrix to the second apparatus. The second residual information is also determined based on the information about the $j^{th}$ first sparse matrix and the information about the $i^{th}$ first sparse matrix. A difference between the second residual information and the first residual information lies in that third location indication information in the second residual information indicates a residual element less than or equal to the first residual threshold and greater than or equal to a second residual threshold in the residual matrix between the information about the $j^{th}$ first sparse matrix and the information about the $i^{th}$ first sparse matrix, and a second residual element sequence in the second residual information includes a residual element less than or equal to the first residual threshold and greater than or equal to the second residual threshold in the residual matrix. The second residual information transmitted in an incremental process may supplement the first residual information, to enrich the residual information, so that the second apparatus can more accurately construct the $j^{th}$ first sparse matrix based on the first residual information and the second residual information.

Further, the first apparatus may transmit third residual information when performing incremental transmission again in the incremental transmission process. The third residual information is also determined based on the information about the $j^{th}$ first sparse matrix and the information about the $i^{th}$ first sparse matrix, fourth location indication information in the third residual information indicates a residual element less than or equal to the second residual threshold and greater than or equal to a third residual threshold in the residual matrix between the information about the $j^{th}$ first sparse matrix and the information about the $i^{th}$ first sparse matrix, to supplement the first residual information and the second residual information. Certainly, the first apparatus may further transmit more residual information. A quantity of incremental transmissions in the incremental transmission process is not limited in this application.

It should be noted that the first apparatus may incrementally transmit a first sparse matrix corresponding to one or more of the M pieces of subdata, and/or the first apparatus may incrementally transmit one or more of the multiple groups of subdata corresponding to the M pieces of first data.

During Implementation 1 and Implementation 2, the first apparatus may perform compression processing on the compressed data of the M first sparse matrices, for example, perform at least one of scalar quantization, vector quantization, and entropy encoding, and send first residual information obtained through compression processing to the second apparatus, and the second apparatus performs corresponding decompression processing on the compressed data. The compressed data of the M first sparse matrices includes the first compressed data and/or the second compressed data during Implementation 1, or includes the first residual information and/or the second residual information during Implementation 2.

All thresholds such as a capability threshold, a similarity threshold, and a residual threshold (including the first residual threshold to a fourth residual threshold) during Implementation 1 and Implementation 2 may be preset or preconfigured. That the thresholds are preset may mean, for example, that the thresholds are defined in a protocol or prestored in a device, and that the thresholds are preconfigured may mean, for example, that the thresholds are preconfigured by the network device for the terminal device.

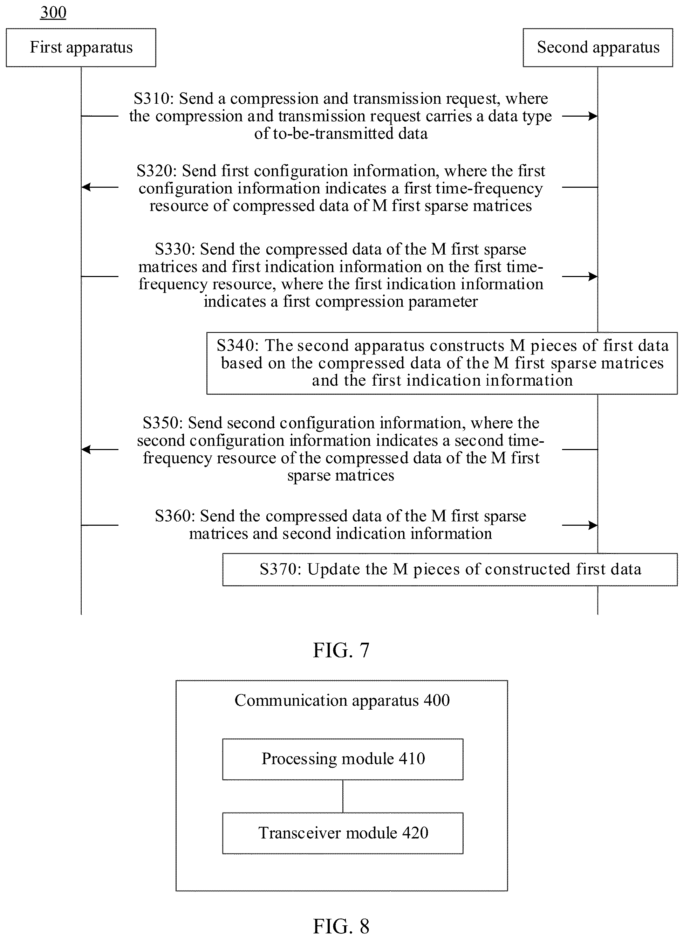

FIG. 7 is a schematic interaction flowchart of another data compression and transmission method according to an embodiment of this application. As shown in FIG. 7, a method 300 includes some or all processes in S310 to S390.

S310: A first apparatus sends a compression and transmission request to a second apparatus, where the compression and transmission request carries a data type of to-be-transmitted data. Correspondingly, the second apparatus receives the compression and transmission request sent by the first apparatus.

S320: The second apparatus sends first configuration information to the first apparatus, where the first configuration information indicates a first time-frequency resource of M pieces of first data. Correspondingly, the first apparatus receives the first configuration information and/or first indication information that are/is sent by the second apparatus.

S330: The first apparatus sends compressed data of M first sparse matrices and the first indication information on the first time-frequency resource, where the first indication information indicates a first compression parameter. Correspondingly, the second apparatus receives, on the first time-frequency resource, the compressed data of the M first sparse matrices and the first indication information that are sent by the first apparatus.

S340: The second apparatus constructs the M pieces of first data based on the compressed data of the M first sparse matrices and the first indication information.

S350: The second apparatus sends second configuration information to the first apparatus, where the second configuration information indicates a second time-frequency resource of the compressed data of the M first sparse matrices. Correspondingly, the first apparatus receives the second configuration information sent by the second apparatus.

S360: The first apparatus sends the compressed data of the M first sparse matrices and second indication information on the second time-frequency resource. Correspondingly, the second apparatus receives, on the second time-frequency resource, the compressed data of the M first sparse matrices and the second indication information that are sent by the first apparatus.

S370: The second apparatus updates the M pieces of constructed first data.

It should be noted that an initial transmission process is a basis of an incremental transmission process. When there is no incremental transmission, the initial transmission process is a complete compression and transmission process. When the method 300 includes S350 to S370, S310 to S340 are the initial transmission process, and S350 to S370 are an incremental transmission process. When the method 300 does not include S350 and S370, S310 to S340 are a compression and transmission process.

When S310 to S340 are implemented as the initial transmission process, the first time-frequency resource is a time-frequency resource occupied in the initial transmission process, and compressed data of the M pieces of first data that is transmitted on the first time-frequency resource in the initial transmission process is, for example, the first compressed data during Implementation 1 and the first residual information during Implementation 2, and may further include compressed data of a first dictionary matrix. The first compression parameter is a compression parameter in the initial transmission process. The second time-frequency resource is a time-frequency resource occupied in the incremental transmission process. The compressed data of the M first sparse matrices is compressed data transmitted on the second time-frequency resource in the incremental transmission process, for example, the second compressed data during Implementation 1 and the second residual information during Implementation 2.

Optionally, the data type includes point cloud data or AI model data.

Optionally, the compression and transmission request may be a status report (status report, SR) or a buffer status report (buffer status report, BSR). For example, the first apparatus may send the compression and transmission request by using the SR, to indicate the data type, or a first communication apparatus may send the compression and transmission request by using the BSR, to report a size of the to-be-transmitted data (for example, the M first sparse matrices and/or the first dictionary matrix).

In S310, the first apparatus sends the compression and transmission request to the second apparatus, to request to perform compression and transmission on the M first sparse matrices. The compression and transmission request may carry the data type of the to-be-transmitted data and/or the size of the to-be-transmitted data.

The second apparatus may determine, based on the data type of the to-be-transmitted data and/or the size of the to-be-transmitted data, the first time-frequency resource for transmitting the compressed data of the M first sparse matrices. Optionally, if the first data is large and the compressed data of the M first sparse matrices needs to be transmitted in an incremental transmission manner, the second apparatus may first determine the first time-frequency resource of the compressed data of the M first sparse matrices in the initial transmission process.

Before S330, in this embodiment, the compressed data of the M first sparse matrices may be further determined based on the method in any one of the foregoing embodiments. For brevity, details are not described again.

Based on any one of the foregoing embodiments, the first apparatus may determine the first compression parameter based on the first time-frequency resource, and then perform data compression based on the first compression parameter. The first compression parameter includes at least one of the following:

(1) a capability threshold, where the capability threshold is used to determine whether an element in the first sparse matrix is capable of representing one piece of corresponding subdata in the first data;
(2) a first residual threshold, where the first residual threshold is used to determine a first residual element sequence, the first residual element sequence represents a residual matrix between information about a $j^{th}$ first sparse matrix and information about an $i^{th}$ first sparse matrix, i is less than j, and both i and j are positive integers; and
(3) a compression processing parameter, where the compression processing parameter includes at least one of quantization precision, a quantization codebook, and an encoding manner. The compression processing parameter may indicate an encoding manner, quantization precision, a quantization codebook, and the like of each of the first dictionary matrix, the first compressed data, and the first residual information. Optionally, the encoding manner may include scalar quantization, vector quantization, entropy encoding, and the like.

Optionally, in a scalar quantization manner, the compression processing parameter may further include a quantization range of the scalar quantization; and in a vector quantization manner, the compression processing parameter may further include a quantization codebook corresponding to the vector quantization.

In S330, the first indication information and the first compressed data may be sent together on the first time-frequency resource. However, this is not limited in this application. For example, the first indication information may be separately sent, and an execution sequence of sending the first indication information and sending the first compressed data by the first apparatus is not limited. Alternatively, the first indication information may be sent by the second apparatus to the first apparatus, to indicate data compression of the first apparatus, or content indicated by the first indication information may be agreed on in a protocol.

The first indication information indicates at least one of the following:

(1) a quantity $K_0$ of features of low-rank approximation: For example, $K_0$ may be equal to 4 or 8 based on Manner 2 in which data division is performed in a spatial dimension. However, this is not limited in this application. A value of $K_0$ may be adaptively adjusted based on an application scenario or a communication service;
(2) a quantity M of pieces of the first data: The quantity M of pieces of first data may be adaptively adjusted based on an application scenario or a communication service. Optionally, the quantity M of pieces of the first data may be associated with $K_0$. For example, based on Manner 2 in which data division is performed in a time dimension, when $K_0$ is equal to 4, M may be equal to 2, and when $K_0$ is equal to 8, M may be equal to 4. Based on Manner 1 in which data division is performed in the time dimension, when the to-be-transmitted data is AI data, the quantity M of pieces of first data may be equal to 10; and when the to-be-transmitted data is point cloud data, the quantity M of pieces of first data is associated with a scanning frequency at which point cloud data is collected. For example, if a rotating scanning frequency of a lidar (lidar) is usually 20 Hz, the quantity M of pieces of first data may be equal to 5;
(3) the capability threshold;
(4) the first residual threshold;
(5) a proportion of elements, in one of the M first sparse matrices, capable of representing one piece of corresponding subdata in the first data;
(6) a data loss of the first compressed data relative to the M first sparse matrices;
(7) the compression processing parameter; and
(8) whether to send the first residual information.

(1) The quantity $K_0$ of features of low-rank approximation; (2) the capability threshold; (4) the first residual threshold; (5) the proportion of elements, in the first sparse matrix, capable of representing one piece of corresponding subdata in the first data; and (6) the data loss of the first compressed data may be all used by the second apparatus to determine whether the M pieces of first data (or the M first sparse matrices) need to be compressed and transmitted in an incremental transmission manner. (4) The first residual threshold and (7) the compression processing parameter may indicate the first apparatus to perform data compression and indicate the second apparatus to decompress the first compressed data. (1) The quantity $K_0$ of features of low-rank approximation; (2) the quantity M of pieces of first data; (3) the capability threshold; (4) the first residual threshold; and (8) whether to send the first residual information may be all used by the first apparatus to perform data compression and used by the second apparatus to perform data construction.

For example, during Implementation 1, the first indication information may include one or more of fields shown in Table 1.

Table 1

| Data divi-sion mode | Data divi-sion dimen-sion | Compression in-dication of a first dictionary matrix | Compression indication of $K_0$ feature values | Compression indication of feature vectors correspond-ing to the $K_0$ feature values | Compression status |
|---|---|---|---|---|---|
| | | | | | |

The compression status is used by the second apparatus to determine whether the first data needs to be compressed and transmitted in the incremental transmission manner. The compression status field may include at least one of: (1) the quantity of features $K_0$ of low-rank approximation; (2) the capability threshold; (4) the first residual threshold; (5) the proportion of elements, in the first sparse matrix, capable of representing one piece of corresponding subdata in the first data; and (6) the data loss of the first compressed data.

Optionally, in the first indication information shown in Table 1, the compression indication of a first dictionary matrix field may indicate compression precision of the first dictionary matrix. For example, if one group of subdata in the M pieces of first data shares the first dictionary matrix, high-precision (for example, 32 bits) quantization may be indicated to be performed on the first dictionary matrix by using a quantizer. The compression indication of $K_0$ feature values is similar to the compression indication of a first dictionary matrix. Details are not described again. In addition/alternatively, the compression indication of a first dictionary matrix field may indicate a compression manner of the first dictionary matrix, for example, indicate a compression manner such as quantization or entropy encoding.

Optionally, in the first indication information shown in Table 1, the compression indication of feature vectors corresponding to the $K_0$ feature values field may indicate a compression manner of the feature vector, for example, indicate a compression manner such as quantization, entropy encoding, or dictionary learning. Further, at least one of the quantization precision, the quantization codebook, and the encoding manner may be indicated.

Optionally, the data division mode field may indicate to perform data division in the time dimension in Manner 1, or indicate to perform data division in the spatial dimension in Manner 2.

Optionally, the data division dimension field may include an indication of the quantity M of pieces of first data, an indication of a quantity of pieces of subdata in the first data, and/or the like.

In some embodiments, the compression indication of a first dictionary matrix field, the compression indication of $K_0$ feature values field, and the compression indication of feature vectors corresponding to the $K_0$ feature values field in Table 1 are all mandatory fields, and the data division mode field, the data division dimension field, and the compression status field are all optional fields.

For example, during Implementation 2, the first indication information may include one or more of fields shown in Table 2.

Table 2

| Compression status | Compression indication of a first residual element sequence | Compression indication of second location indication information | Whether to send first residual information | Compression indication of an element sequence | Compression indication of first location indication information | Compression indication of a first dictionary matrix | Data division dimension | Data division mode |
|---|---|---|---|---|---|---|---|---|

The data division mode field, the data division dimension field, and the compression status field are all similar to those in Table 1. Details are not described herein again.

Optionally, any one of the foregoing compression indication fields such as the compression indication of a first dictionary matrix field, the compression indication of first location indication information field, the compression indication of second location indication information field, and a compression indication of a first residual element sequence field each may indicate a compression manner and/or compression precision of corresponding data. For example, the compression indication of a first dictionary matrix field indicates to perform 32-bit high-precision quantization on the first dictionary matrix. For another example, the compression indication of first location indication information field indicates to compress the first location indication information in a manner of (Lempel-Ziv 77, LZ77) or (Lempel-Ziv-Markov chain algorithm, LZMA), and the compression indication of second location indication information field indicates to compress the second location indication information in a manner of LZ77 or LZMA. LZ77 is a dictionary-based sliding window lossless compression algorithm invented by Lempel-Ziv in 1977. LZMA is a compression algorithm improved based on LZ77 and features a high compression rate, a high decompression speed, and low memory consumption. For another example, the compression indication of an element sequence field indicates quantization precision and/or a quantization range when scalar quantization is performed on the element sequence, or the compression indication of an element sequence field indicates quantization precision and/or a quantization codebook when vector quantization is performed on the element sequence, or the compression indication of an element sequence field indicates an encoding manner when entropy encoding is performed on the element sequence. The first residual element sequence is similar to this and is not described again.

The foregoing compression manners are merely examples rather than limitative descriptions. The compression manner of the first location indication information may further include any other compression algorithm. Examples are not enumerated.

The first location indication information and the element sequence are determined based on a basic sparse matrix, and the second location indication information and the first residual element sequence are determined based on the information about the $j^{th}$ first sparse matrix and the information about the $i^{th}$ first sparse matrix.

Optionally, the whether to send the first residual information field may indicate, by using 1 bit, whether to send first residual information corresponding to the $j^{th}$ first sparse matrix. For example, when the whether to send the first residual information field is 0, it indicates not to send the first residual information corresponding to the $j^{th}$ first sparse matrix; or when the whether to send the first residual information field is 1, it indicates to send the first residual information corresponding to the $i^{th}$ first sparse matrix. Certainly, a value of the whether to send the first residual information field is not limited in this application.

In a scenario with a high delay requirement, to reduce impact of a delay on a communication service, the first indication information may indicate to perform joint compression on the M first sparse matrices in the foregoing residual-based manner. In a scenario with a low delay requirement, the first indication information may indicate to perform joint compression on the M first sparse matrices in the foregoing low-rank approximation-based manner.

In S340, the second apparatus decompresses the compressed data of the M first sparse matrices based on an indication of the first indication information, to construct the M pieces of subdata corresponding to the M first sparse matrices, and performs data construction on other subdata in the M pieces of first data in a similar manner, to obtain the M pieces of first data.

In S350, the second apparatus may determine, based on construction quality of the M pieces of first data constructed in S340 and/or a compression status of the compressed data of the M first sparse matrices, whether incremental transmission needs to be performed, and send the second configuration information to the first apparatus when incremental transmission needs to be performed. For example, the second apparatus generates and sends the second configuration information when the construction quality of the M pieces of first data (or the M pieces of subdata) is poor. For another example, the second apparatus sends the second configuration information when the compression status field indicates that the data loss of the first compressed data relative to the M first sparse matrices exceeds a threshold. The compression status may be indicated by the compression status field.

Based on any one of the foregoing embodiments, the first apparatus may calculate, based on the second time-frequency resource, a total quantity of bits that can be transmitted; determine a second compression parameter; and perform data compression based on the second compression parameter. The second compression parameter includes a second residual threshold, so that the first apparatus determines, with reference to the second residual threshold, a residual element to be sent in the incremental transmission process. Correspondingly, the second apparatus determines, with reference to the second residual threshold, a residual element sent by the first apparatus in the incremental process.

In S360, the second indication information may be sent on the second time-frequency resource together with the compressed data (for example, the first compressed data or the second residual information) of the M first sparse matrices. However, this is not limited in this application. For example, the second indication information may be separately sent, and an execution sequence of sending the second indication information and sending the compressed data by the first apparatus is not limited. Alternatively, the second indication information may be sent by the second apparatus to the first apparatus, to indicate data compression to be performed by the first apparatus in the incremental transmission process; or content indicated by the second indication information may be agreed on in a protocol.

The second indication information may indicate to perform incremental transmission through low-rank approximation. In this case, the second indication information may indicate the quantity $K_1$ of features of low-rank approximation; or the second indication information may indicate to perform incremental transmission based on a residual. In this case, the second indication information may indicate a second residual threshold, for example, indicate the second residual threshold.

For example, during Implementation 1, the second indication information may include one or more of fields shown in Table 3.

Table 3

| Incremental trans-mission mode indi-cation | Location indica-tion | Quantity $K_1$ of features | Compression indi-cation of $K_1$ feature values | Compression indication of feature vectors corresponding to the $K_1$ feature values |
|---|---|---|---|---|

Optionally, the incremental transmission mode indication field may indicate whether incremental transmission is performed through low-rank approximation or in a residual-based manner.

Optionally, the location indication field may indicate first data that needs to be incrementally transmitted in the M pieces of first data, or subdata that needs to be incrementally transmitted in the first data.

For the compression indication of $K_1$ feature values field, refer to the descriptions of the compression indication of $K_0$ feature values field in the foregoing example. For the compression indication of feature vectors corresponding to the $K_1$ feature values field, refer to the descriptions of the compression indication of feature vectors corresponding to the $K_0$ feature values field in the foregoing example. For brevity, details are not described again.

For example, during Implementation 2, the second indication information may include one or more of fields shown in Table 4.

Table 4

| Incremental transmission mode indication | Location indication | Compression indication of third location indication information | Compression indication of a second residual element sequence |
|---|---|---|---|

For the incremental transmission mode indication field and the location indication field, refer to the descriptions in Table 3. For the compression indication of third location indication information field, refer to the descriptions of the compression indication of second location indication information field in the foregoing example. For the compression indication of a second residual element sequence field, refer to the descriptions of the compression indication of a first residual element sequence field in the foregoing example.

In S370, the second apparatus may update the M pieces of constructed first data based on the second compressed data of the M first sparse matrices or a supplement of the second residual information to the M pieces of constructed subdata.

It should be understood that the embodiment shown in FIG. 7 is described by using only one incremental transmission as an example. A quantity of incremental transmissions is not limited in this embodiment of this application. The first apparatus and the second apparatus may further perform incremental transmission based on S350 to S370 or in a similar manner.

FIG. 8 is a schematic block diagram of a communication apparatus according to an embodiment of this application. A communication apparatus 400 may be a terminal or network device, may be an apparatus in a terminal device or a network device, or may be an apparatus that can be used together with a terminal device or a network device. In a possible implementation, the communication apparatus 400 may include modules or units that are in one-to-one correspondence with the methods/operations/steps/actions performed by the first apparatus or the second apparatus in the foregoing method embodiments, and the unit may be implemented by a hardware circuit, software, or a combination of a hardware circuit and software. In a possible implementation, as shown in FIG. 8, the apparatus 400 may include a processing module 410 and a transceiver module 420.

Optionally, the communication apparatus 400 may correspond to the first apparatus in the foregoing method embodiments.

When the communication apparatus 400 is configured to perform the method on the first apparatus side, the processing module 410 may be configured to obtain M pieces of first data, where one piece of subdata in the first data corresponds to one first sparse matrix, the first sparse matrix represents one piece of corresponding subdata in the first

**EP 4 645 833 A1**

data based on a first dictionary matrix, and the first dictionary matrix includes features of M pieces of subdata respectively corresponding to the M pieces of first data; and the transceiver module 420 may be configured to output compressed data of the M first sparse matrices, where M is an integer greater than 1.

It should be understood that specific processes performed by the modules are described in detail in the foregoing method embodiments. For brevity, details are not described herein again.

Optionally, the communication apparatus 400 may correspond to the second apparatus in the foregoing method embodiments.

When the communication apparatus 400 is configured to perform the method on the second apparatus side, the transceiver module 420 may be configured to receive compressed data of M first sparse matrices, where the first sparse matrix represents corresponding subdata in the first data based on a first dictionary matrix, the first dictionary matrix includes features of M pieces of subdata respectively corresponding to M pieces of first data, and one piece of subdata in the first data corresponds to one first sparse matrix; and the processing module 410 may be configured to output decompression information based on the compressed data.

It should be understood that specific processes performed by the modules are described in detail in the foregoing method embodiments. For brevity, details are not described herein again.

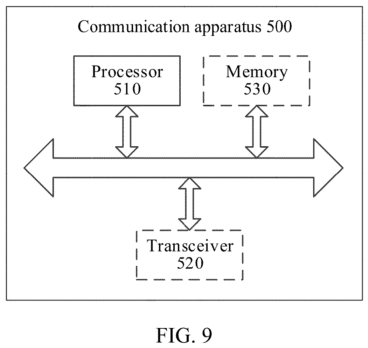

The transceiver module 420 in the communication apparatus 400 may be implemented by using a transceiver, for example, may correspond to a transceiver 520 in a communication apparatus 500 shown in FIG. 9. The processing module 410 in the communication apparatus 400 may be implemented by using at least one processor, for example, may correspond to a processor 510 in the communication apparatus 500 shown in FIG. 9.

When the communication apparatus 400 is a chip or a chip system configured in a communication device (for example, a terminal device or a network device), the transceiver module 420 in the communication apparatus 400 may be implemented by using an input/output interface, a circuit, or the like, and the processing module 410 in the communication apparatus 400 may be implemented by using a processor, a microprocessor, an integrated circuit, or the like integrated on the chip or the chip system.

FIG. 9 is another schematic block diagram of a communication apparatus according to an embodiment of this application. As shown in FIG. 9, the communication apparatus 500 may include a processor 510. The processor 510 may be configured to perform the method performed by the first apparatus or the second apparatus in the foregoing method embodiments.

In some possible implementations, the communication apparatus 500 may include the transceiver 520. The transceiver 520 and the processor 510 may communicate with each other through an internal connection path. The processor 510 may control the transceiver 520 to send a signal and/or receive a signal.

In some possible implementations, the communication apparatus 500 may include a memory 530. The memory 530 and the processor 510 may communicate with each other through an internal connection path. The memory 530 and the processor 510 may be integrated together, or may be disposed separately. The memory 530 may alternatively be a memory outside the apparatus. The memory 530 is configured to store instructions, and the processor 510 is configured to execute the instructions stored in the memory 530, to perform the methods in the foregoing method embodiments.

It should be understood that the communication apparatus 500 may correspond to the terminal device or the network device in the foregoing method embodiments, and may be configured to perform steps and/or procedures performed by the first apparatus or the second apparatus in the foregoing method embodiments. Optionally, the memory 530 may include a read-only memory and a random access memory, and provide instructions and data for the processor. A part of the memory may further include a non-volatile random access memory. The memory 530 may be a separate component, or may be integrated in the processor 510. The processor 510 may be configured to execute the instructions stored in the memory 530. When the processor 510 executes the instructions stored in the memory, the processor 510 is configured to perform the steps and/or procedures corresponding to the terminal device or the network device in the foregoing method embodiments.

Optionally, the communication apparatus 500 is the first apparatus in the foregoing embodiments.

Optionally, the communication apparatus 500 is the second apparatus in the foregoing embodiments.

The transceiver 520 may include a transmitter and a receiver. The transceiver 520 may further include one or more antennas. The processor 510, the memory 530, and the transceiver 520 may be devices integrated in different chips. For example, the processor 510 and the memory 530 may be integrated in a baseband chip, while the transceiver 520 may be integrated in a radio frequency chip. The processor 510, the memory 530, and the transceiver 520 may alternatively be devices integrated in a same chip. This is not limited in this application.

Optionally, the communication apparatus 500 is a component configured in the terminal device, for example, a chip or a chip system.

Optionally, the communication apparatus 500 is a component configured in the network device, for example, a chip or a chip system.

The transceiver 520 may alternatively be a communication interface, for example, an input/output interface or a circuit. The transceiver 520, the processor 510, and the memory 530 may be integrated in a same chip, for example, integrated in a baseband chip.

This application further provides a processing apparatus, including at least one processor. The at least one processor is configured to run a computer program or a logic circuit, so that the processing apparatus performs the method performed by the first apparatus or the second apparatus in the foregoing method embodiments. The processing apparatus may further include a memory, and the memory is configured to store the computer program.

An embodiment of this application further provides a processing apparatus, including a processor and an input/output interface. The input/output interface is coupled to the processor. The input/output interface is configured to input and/or output information. The information includes at least one of instructions and data. The processor is configured to execute a computer program, so that the processing apparatus performs the method performed by the first apparatus or the second apparatus in the foregoing method embodiments.

An embodiment of this application further provides a processing apparatus, including a processor and a memory. The memory is configured to store a computer program. The processor is configured to invoke the computer program from the memory and run the computer program, so that the processing apparatus performs the method performed by the first apparatus or the second apparatus in the foregoing method embodiments.

It should be understood that, the processing apparatus may be one or more chips. For example, the processing apparatus may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a microcontroller (micro controller unit, MCU), a programmable controller (programmable logic device, PLD), or another integrated chip.

In an implementation process, steps in the foregoing methods can be implemented by using a hardware integrated logical circuit in the processor, or by using instructions in a form of software. The steps in the methods disclosed with reference to embodiments of this application may be directly performed and completed by a hardware processor, or may be performed and completed by using a combination of hardware in the processor and a software module. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor. To avoid repetition, details are not described herein again.

The processor in embodiments of this application may be an integrated circuit chip, and has a signal processing capability. In an implementation process, steps in the foregoing method embodiments can be implemented by using a hardware integrated logical circuit in the processor, or by using instructions in a form of software. The processor may be a general purpose processor, a digital signal processor (DSP), an application specific integrated circuit (ASIC), a field programmable gate array (FPGA) or another programmable logic device, a discrete gate or a transistor logic device, or a discrete hardware component. It may implement or perform the methods, the steps, and logical block diagrams that are disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware in the decoding processor and a software module. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor.

It may be understood that the memory in this embodiment of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM). It should be noted that the memory of the systems and methods described in this specification includes but is not limited to these and any memory of another proper type.

According to the method provided in embodiments of this application, this application further provides a computer program product. The computer program product includes a computer program or a group of instructions. When the computer program or the group of instructions are run on a computer, the computer is enabled to perform the method performed by the first apparatus or the second apparatus in the foregoing method embodiments.

According to the method provided in embodiments of this application, this application further provides a computer-readable storage medium. The computer-readable storage medium stores a program. When the program is run on a computer, the computer is enabled to perform the method performed by the first apparatus or the second apparatus in the foregoing method embodiments.

According to the method provided in embodiments of this application, this application further provides a communication system. The communication system may include the first apparatus and the second apparatus described above.

Terms such as "component", "module", and "system" used in this specification are used to indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As illustrated by using figures, both a computing device and an application that runs on the computing device may be components. One or more components may reside within a process and/or a thread of execution, and a component may be located on one computer and/or distributed between two or more computers. In addition, these components may be executed from various computer-readable media that store various data structures. For example, the components may communicate by using a local and/or remote process and based on, for example, a signal having one or more data packets (for example, data from two components interacting with another component in a local system, a distributed system, and/or across a network such as the Internet interacting with other systems by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, the disclosed systems, apparatuses and methods may be implemented in other manners. For example, the described apparatus embodiment is merely an example. For example, division into the units is merely logical functional division and may be other division in actual implementation. For example, multiple units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one place, or may be distributed on multiple network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on this understanding, a part that essentially contributes to the technical solutions of this application or a part of the technical solutions may be embodied in a form of a software product. The computer software product is stored in a storage medium, and includes several instructions for enabling a computer device (which may be a personal computer, a server, a network device, or the like) to perform all or some steps in the methods in embodiments of this application. The foregoing storage medium includes any medium that can store program code, such as a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data compression and transmission method, comprising:

obtaining M pieces of first data, wherein one piece of subdata in the first data corresponds to one first sparse matrix, the first sparse matrix represents one piece of corresponding subdata in the first data based on a first dictionary matrix, and the first dictionary matrix comprises features of M pieces of subdata respectively corresponding to the M pieces of first data; and
outputting compressed data of the M first sparse matrices, wherein M is an integer greater than 1.

2. The method according to claim 1, wherein for a $p^{th}$ piece of first data and a $q^{th}$ piece of first data in the M pieces of first data, a similarity between one piece of subdata in the $p^{th}$ piece of first data and one piece of subdata in the $q^{th}$ piece of first data is greater than or equal to a first similarity threshold; and
both p and q are positive integers, and p is not equal to q.

3. The method according to claim 1 or 2, wherein the M pieces of first data are respectively data in M time units, one piece of first data comprises N pieces of subdata obtained through division based on a spatial location relationship, and N is a positive integer; or

the M pieces of first data are data in h time units, the data in the h time units is sorted based on a spatial location relationship, to obtain the M pieces of first data, one piece of first data comprises N pieces of subdata, and h is a positive integer; and
a similarity between a spatial location of one piece of subdata in the $p^{th}$ piece of first data and a spatial location of one piece of subdata in the $q^{th}$ piece of first data in the M pieces of first data is greater than or equal to the first similarity threshold.

4. The method according to any one of claims 1 to 3, wherein the method further comprises:

for a $k^{th}$ piece of first data $Y_k$ in the M pieces of first data, decomposing one piece of subdata in the $k^{th}$ piece of first data $Y_k$ into the first dictionary matrix and a $k^{th}$ first sparse matrix, wherein k is a positive integer less than or equal to M; and
determining M-1 first sparse matrices other than the $k^{th}$ first sparse matrix based on the first dictionary matrix.

5. The method according to any one of claims 1 to 4, wherein the outputting the compressed data of the M first sparse matrices comprises:

determining a first matrix based on the M first sparse matrices;
performing low-rank approximation on the first matrix, to obtain first compressed data of the M first sparse matrices; and
outputting the first compressed data.

6. The method according to claim 5, wherein the determining the first matrix based on the M first sparse matrices comprises:

combining the M first sparse matrices, to obtain the first matrix; or
performing data compression on at least one of the M first sparse matrices, and combining M first sparse matrices obtained through data compression, to obtain the first matrix.

7. The method according to claim 6, wherein the performing data compression on the at least one of the M first sparse matrices comprises:

for one of the M first sparse matrices, setting a value of a first element in the one first sparse matrix to a first value based on first location indication information, wherein
the first location indication information indicates a location of an element, in the first sparse matrix, capable of representing one piece of corresponding subdata, and the first element is incapable of representing one piece of subdata in the first data.

8. The method according to any one of claims 5 to 7, wherein the performing low-rank approximation on the first matrix, to obtain the first compressed data of the M first sparse matrices comprises:

performing singular value decomposition on the first matrix, to obtain K feature values and feature vectors respectively corresponding to the K feature values, wherein the K feature values and the feature vectors respectively corresponding to the K feature values represent the first matrix; and

using $K_0$ feature values in the K feature values and feature vectors respectively corresponding to the $K_0$ feature values as the first compressed data of the M first sparse matrices.

9. The method according to claim 8, further comprising:

outputting second compressed data of the M first sparse matrices, wherein the second compressed data comprises $K_1$ feature values other than the $K_0$ feature values in the K feature values and feature vectors respectively corresponding to the $K_1$ feature values.

10. The method according to any one of claims 1 to 4, wherein the outputting the compressed data of the M first sparse matrices comprises:

outputting first residual information, wherein the first residual information is determined based on information about a $j^{th}$ first sparse matrix and information about an $i^{th}$ first sparse matrix in the M first sparse matrices, wherein i is less than j, and both i and j are positive integers.

11. The method according to claim 10, wherein the outputting the first residual information comprises:

determining a similarity between the $j^{th}$ first sparse matrix and the $i^{th}$ first sparse matrix in the M first sparse matrices; and

outputting the first residual information when the similarity is less than or equal to a second similarity threshold.

12. The method according to claim 10 or 11, wherein the information about the $i^{th}$ first sparse matrix is obtained by decompressing compressed data of the $i^{th}$ first sparse matrix.

13. The method according to any one of claims 10 to 12, wherein the first residual information comprises a first residual element sequence, the first residual element sequence represents a residual matrix between the information about the $j^{th}$ first sparse matrix and the information about the $i^{th}$ first sparse matrix, i is less than j, and both i and j are positive integers.

14. The method according to claim 13, wherein the first residual information further comprises second location indication information, and the second location indication information indicates an absolute value is greater than or equal to in the residual matrix between the information about the $j^{th}$ first sparse matrix and the information about the $i^{th}$ first sparse matrix.

15. The method according to any one of claims 10 to 14, further comprising:

outputting second residual information, wherein the second residual information is determined based on the information about the $j^{th}$ first sparse matrix and the information about the $i^{th}$ first sparse matrix, wherein the second residual information comprises third location indication information and a second residual element sequence, the third location indication information indicates a residual element less than or equal to the first residual threshold and greater than or equal to a second residual threshold in the residual matrix between the information about the $j^{th}$ first sparse matrix and the information about the $i^{th}$ first sparse matrix, and the second residual element sequence comprises a residual element less than or equal to the first residual threshold and greater than or equal to the second residual threshold in the residual matrix.

16. The method according to any one of claims 1 to 15, wherein the method further comprises:

sending the first dictionary matrix; or
receiving the first dictionary matrix.

17. The method according to any one of claims 5 to 9, wherein the outputting the first compressed data comprises:

performing compression processing on the first compressed data, wherein the compression processing comprises quantization and/or entropy encoding; and
outputting first compressed data obtained through compression processing.

18. The method according to claim 11, wherein the outputting the first residual information comprises:

performing compression processing on the first residual information, wherein the compression processing comprises quantization and/or entropy encoding; and

outputting first residual information obtained through compression processing.

19. The method according to any one of claims 1 to 18, further comprising:

sending first indication information; or
receiving first indication information, wherein
the first indication information indicates at least one of the following:

a quantity $K_0$ of features of low-rank approximation;
a quantity M of pieces of first data;
a capability threshold, wherein the capability threshold is used to determine whether an element in the first sparse matrix is capable of representing one piece of corresponding subdata in the first data;
the first residual threshold, wherein the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers;
a proportion of elements, in one of the M first sparse matrices, capable of representing one piece of corresponding subdata in the first data;
a data loss of the first compressed data relative to the M first sparse matrices, wherein the first compressed data is determined based on the M first sparse matrices;
a compression processing parameter, wherein the compression processing comprises quantization and/or entropy encoding, and the compression processing parameter comprises at least one of quantization precision, a quantization codebook, and an encoding manner; and
whether to send the first residual information, wherein the first residual information is determined based on the information about the $j^{th}$ first sparse matrix and the information about the $i^{th}$ first sparse matrix in the M first sparse matrices.

20. The method according to any one of claims 1 to 19, further comprising:
determining at least one of the following based on a first time-frequency resource of the M pieces of first data:

the capability threshold, wherein the capability threshold is used to determine whether the element in the first sparse matrix is capable of representing one piece of corresponding subdata in the first data;
the first residual threshold, wherein the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers; and
the compression processing parameter, wherein the compression processing comprises quantization and/or entropy encoding, and the compression processing parameter comprises at least one of the quantization precision, the quantization codebook, and the encoding manner.

21. The method according to claim 20, further comprising:
receiving first configuration information, wherein the first configuration information is used to configure the first time-frequency resource.

22. The method according to claim 21, further comprising:
sending a compression and transmission request, wherein the compression and transmission request carries a data type of the M pieces of first data, and the data type comprises point cloud data and/or artificial intelligence AI data.

23. The method according to any one of claims 1 to 22, further comprising:

sending second indication information; or
receiving second indication information, wherein
the second indication information indicates at least one of the following:

a quantity $K_1$ of features of low-rank approximation; and
the second residual threshold, wherein the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

24. The method according to any one of claims 1 to 23, further comprising:
determining the second residual threshold based on a second time-frequency resource of the M pieces of first data, wherein the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

25. The method according to claim 24, further comprising:
receiving second configuration information, wherein the second configuration information is used to configure the second time-frequency resource.

26. A data compression and transmission method, comprising:

receiving compressed data of M first sparse matrices, wherein the first sparse matrix represents corresponding subdata in first data based on a first dictionary matrix, the first dictionary matrix comprises features of M pieces of subdata respectively corresponding to M pieces of first data, and one piece of subdata in the first data corresponds to one first sparse matrix; and
outputting decompression information based on the compressed data.

27. The method according to claim 26, wherein for a $p^{th}$ piece of first data and a $q^{th}$ piece of first data in the M pieces of first data, a similarity between one piece of subdata in the $p^{th}$ piece of first data and one piece of subdata in the $q^{th}$ piece of first data is greater than or equal to a first similarity threshold; and
both p and q are positive integers, and p is not equal to q.

28. The method according to claim 26 or 27, wherein the M pieces of first data are respectively data in M time units, one piece of first data comprises N pieces of subdata obtained through division based on a spatial location relationship, and N is a positive integer; or

the M pieces of first data are data in h time units, the data in the h time units is sorted based on a spatial location relationship, to obtain the M pieces of first data, one piece of first data comprises N pieces of subdata, and h is a positive integer; and
a similarity between a spatial location of one piece of subdata in the $p^{th}$ piece of first data and a spatial location of one piece of subdata in the $q^{th}$ piece of first data in the M pieces of first data is greater than or equal to the first similarity threshold.

29. The method according to any one of claims 26 to 28, wherein the compressed data comprises first compressed data, and the outputting the decompression information based on the compressed data comprises:

performing low-rank matrix recovery based on the first compressed data, to obtain a first matrix;
determining the M first sparse matrices based on the first matrix;
constructing the M pieces of first data based on the M first sparse matrices and the first dictionary matrix; and
outputting the M pieces of first data.

30. The method according to claim 29, wherein the determining the M first sparse matrices based on the first matrix comprises:

splitting the first matrix, to obtain the M first sparse matrices; or
splitting the first matrix, to obtain decompression information of the M first sparse matrices, and performing data decompression on at least one of the M first sparse matrices based on the information about the M first sparse matrices.

31. The method according to claim 30, wherein the performing data decompression on the at least one of the M first sparse matrices comprises:

for one of the M first sparse matrices, performing data decompression on the first sparse matrix based on first location indication information, wherein

the first location indication information indicates a location of an element, in the first sparse matrix, capable of representing one piece of corresponding subdata.

32. The method according to any one of claims 29 to 31, wherein the first compressed data comprises $K_0$ feature values and feature vectors respectively corresponding to the $K_0$ feature values, and the performing low-rank matrix recovery based on the first compressed data, to obtain the first matrix comprises:

performing low-rank matrix recovery based on the $K_0$ feature values and the feature vectors respectively corresponding to the $K_0$ feature values, to obtain the first matrix.

33. The method according to claim 32, wherein the compressed data further comprises second compressed data, the second compressed data comprises $K_1$ feature values and feature vectors respectively corresponding to the $K_1$ feature values, and the $K_1$ feature values are different from the $K_0$ feature values.

34. The method according to any one of claims 26 to 28, wherein the compressed data comprises first residual information, the first residual information is determined based on information about a $j^{th}$ first sparse matrix and information about an $i^{th}$ first sparse matrix in the M first sparse matrices, and the outputting the decompression information based on the compressed data comprises:

constructing the $j^{th}$ first sparse matrix based on the first residual information and the $i^{th}$ first sparse matrix;
constructing the M pieces of first data based on the $j^{th}$ first sparse matrix; and
outputting the M pieces of first data, wherein
i is less than j, and both i and j are positive integers.

35. The method according to claim 34, wherein the information about the $i^{th}$ first sparse matrix is obtained by decompressing compressed data of the $i^{th}$ first sparse matrix.

36. The method according to claim 34 or 35, wherein the first residual information comprises a first residual element sequence, the first residual element sequence represents a residual matrix between the information about the $j^{th}$ first sparse matrix and the information about the $i^{th}$ first sparse matrix, i is less than j, and both i and j are positive integers.

37. The method according to claim 36, wherein the first residual information further comprises second location indication information, and the second location indication information indicates a location of a residual element whose absolute value is greater than or equal to a first residual threshold in the residual matrix between the information about the $j^{th}$ first sparse matrix and the information about the $i^{th}$ first sparse matrix.

38. The method according to any one of claims 34 to 37, wherein the compressed data further comprises second residual information, and the second residual information is determined based on the information about the $j^{th}$ first sparse matrix and the information about the $i^{th}$ first sparse matrix; and

the second residual information comprises third location indication information and a second residual element sequence, the third location indication information indicates a residual element less than or equal to the first residual threshold and greater than or equal to a second residual threshold in the residual matrix between the information about the $j^{th}$ first sparse matrix and the information about the $i^{th}$ first sparse matrix, and the second residual element sequence comprises a residual element less than or equal to the first residual threshold and greater than or equal to the second residual threshold in the residual matrix.

39. The method according to any one of claims 26 to 38, wherein the method further comprises:

receiving the first dictionary matrix; or
sending the first dictionary matrix.

40. The method according to any one of claims 26 to 39, further comprising:

receiving first indication information; or
sending first indication information, wherein
the first indication information indicates at least one of the following:

a quantity $K_0$ of features of low-rank approximation;

a quantity M of pieces of first data;

a capability threshold, wherein the capability threshold is used to determine whether an element in the first sparse matrix is capable of representing one piece of corresponding subdata in the first data;

the first residual threshold, wherein the first residual threshold is used to determine the first residual element sequence, the first residual element sequence represents the residual matrix between the information about the $j^{th}$ first sparse matrix and the information about the $i^{th}$ first sparse matrix, i is less than j, and both i and j are positive integers;

a proportion of elements, in one of the M first sparse matrices, capable of representing one piece of corresponding subdata in the first data;

a data loss of the first compressed data relative to the M first sparse matrices, wherein the first compressed data is determined based on the M first sparse matrices;

a compression processing parameter, wherein the compression processing comprises quantization and/or entropy encoding, and the compression processing parameter comprises at least one of quantization precision, a quantization codebook, and an encoding manner; and

whether to send the first residual information, wherein the first residual information is determined based on the information about the $j^{th}$ first sparse matrix and the information about the $i^{th}$ first sparse matrix in the M first sparse matrices.

41. The method according to any one of claims 26 to 40, further comprising:
sending first configuration information, wherein the first configuration information is used to configure a first time-frequency resource of the M pieces of first data.

42. The method according to claim 41, further comprising:
receiving a compression and transmission request, wherein the compression and transmission request carries a data type of the M pieces of first data, and the data type comprises point cloud data and/or artificial intelligence AI data.

43. The method according to any one of claims 26 to 42, further comprising:

receiving sent second indication information; or
sending second indication information, wherein
the second indication information indicates at least one of the following:

a quantity $K_1$ of features of low-rank approximation; and
the second residual threshold, wherein the second residual threshold is used to determine the second residual element sequence in combination with the first residual threshold, the second residual element sequence represents the residual matrix between the information about the $j^{th}$ first sparse matrix and the information about the $i^{th}$ first sparse matrix, i is less than j, and both i and j are positive integers.

44. The method according to any one of claims 26 to 43, further comprising:
receiving second configuration information, wherein the second configuration information is used to configure a second time-frequency resource of the M pieces of first data.

45. A communication apparatus, comprising a module configured to perform the method according to any one of claims 1 to 25 or comprising a module configured to perform the method according to any one of claims 26 to 44.

46. A communication apparatus, comprising a processor, wherein the processor is configured to perform the method according to any one of claims 1 to 44 by running a computer program or by using a logic circuit.

47. A computer-readable storage medium, configured to store computer program instructions, wherein the computer program causes a computer to perform the method according to any one of claims 1 to 44.

48. A computer program product, comprising computer program instructions, wherein the computer program instructions cause a computer to perform the method according to any one of claims 1 to 44.

100

FIG. 1

FIG. 2

200

First apparatus

Second apparatus

S210: The first apparatus obtains M pieces of first data, where one piece of subdata in the first data corresponds to one first sparse matrix, the first sparse matrix represents one piece of corresponding subdata in the first data based on a first dictionary matrix, and the first dictionary matrix includes features of M pieces of subdata respectively corresponding to the M pieces of first data

— S220: Send compressed data of M first sparse matrices →

S230: The second apparatus outputs decompressed data based on the compressed data

FIG. 3

$Y_1$ $\left\{ \begin{array}{l} Y_{(1, 1)} \\ Y_{(1, 2)} \\ \dots \\ Y_{(1, N)} \end{array} \right.$ $Y_2$ $\left\{ \begin{array}{l} Y_{(2, 1)} \\ Y_{(2, 2)} \\ \dots \\ Y_{(2, N)} \end{array} \right.$ ... $Y_M$ $\left\{ \begin{array}{l} Y_{(M, 1)} \\ Y_{(M, 2)} \\ \dots \\ Y_{(M, N)} \end{array} \right.$

Time

FIG. 4a

FIG. 4b

FIG. 5

FIG. 6

300

| First apparatus | | Second apparatus |

S310: Send a compression and transmission request, where the compression and transmission request carries a data type of to-be-transmitted data →

S320: Send first configuration information, where the first ← configuration information indicates a first time-frequency resource of compressed data of M first sparse matrices

S330: Send the compressed data of the M first sparse matrices and first indication information on the first time-frequency resource, where the first indication information → indicates a first compression parameter

S340: The second apparatus constructs M pieces of first data based on the compressed data of the M first sparse matrices and the first indication information

S350: Send second configuration information, where the second configuration information indicates a second time-← frequency resource of the compressed data of the M first sparse matrices

S360: Send the compressed data of the M first sparse matrices and second indication information →

S370: Update the M pieces of constructed first data

FIG. 7

Communication apparatus 400

Processing module 410

Transceiver module 420

FIG. 8

Communication apparatus 500

Processor
510

Memory
530

Transceiver
520

FIG. 9

## INTERNATIONAL SEARCH REPORT

| International application No. |
|---|
| **PCT/CN2023/071916** |

**A.    CLASSIFICATION OF SUBJECT MATTER**

H04L 69/04(2022.01)i

According to International Patent Classification (IPC) or to both national classification and IPC

**B.    FIELDS SEARCHED**

Minimum documentation searched (classification system followed by classification symbols)

IPC： H04L

Documentation searched other than minimum documentation to the extent that such documents are included in the fields searched

Electronic data base consulted during the international search (name of data base and, where practicable, search terms used)

CNTXT, ENTXT, DWPI: 数据, 子数据, 压缩, 稀疏, 字典, 矩阵, 多个, 对应, data, sub-data, compress, sparse, dictionary, matrix, many, multiple, corresponding

**C.    DOCUMENTS CONSIDERED TO BE RELEVANT**

| Category* | Citation of document, with indication, where appropriate, of the relevant passages | Relevant to claim No. |
|---|---|---|
| Y | US 2020327369 A1 (TERAKI GMBH) 15 October 2020 (2020-10-15) description, paragraphs 0024-0054, and figures 1-3 | 1, 16, 19, 26, 39-40, 45-48 |
| Y | CN 114556482 A (KONINKLIJKE PHILIPS N.V.) 27 May 2022 (2022-05-27) description, paragraphs 0006-0109, and figures 1-2 | 1, 16, 19, 26, 39-40, 45-48 |
| A | US 2019197084 A1 (FUJITSU LTD.) 27 June 2019 (2019-06-27) entire document | 1-48 |
| A | US 9167274 B1 (GOOGLE INC.) 20 October 2015 (2015-10-20) entire document | 1-48 |

☐ Further documents are listed in the continuation of Box C.    ☑ See patent family annex.

| * | Special categories of cited documents: | |
|---|---|---|
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T"    later document published after the international filing date or priority date and not in conflict with the application but cited to understand the principle or theory underlying the invention

"X"    document of particular relevance; the claimed invention cannot be considered novel or cannot be considered to involve an inventive step when the document is taken alone

"Y"    document of particular relevance; the claimed invention cannot be considered to involve an inventive step when the document is combined with one or more other such documents, such combination being obvious to a person skilled in the art

"&"    document member of the same patent family

| Date of the actual completion of the international search | Date of mailing of the international search report |
|---|---|
| **17 April 2023** | **21 April 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/071916**

| Patent document cited in search report | | | Publication date (day/month/year) | Patent family member(s) | | | Publication date (day/month/year) |
|---|---|---|---|---|---|---|---|
| US | 2020327369 | A1 | 15 October 2020 | EP | 3722998 | A1 | 14 October 2020 |
| CN | 114556482 | A | 27 May 2022 | EP | 4046279 | A1 | 24 August 2022 |
| | | | | US | 2022368347 | A1 | 17 November 2022 |
| | | | | WO | 2021074440 | A1 | 22 April 2021 |
| | | | | BR | 112022007331 | A2 | 05 July 2022 |
| | | | | JP | 2022553199 | A | 22 December 2022 |
| | | | | IN | 202247025189 | A | 03 June 2022 |
| US | 2019197084 | A1 | 27 June 2019 | WO | 2018135281 | A1 | 26 July 2018 |
| | | | | JP | 2018117208 | A | 26 July 2018 |
| US | 9167274 | B1 | 20 October 2015 | None | | | |

Form PCT/ISA/210 (patent family annex) (July 2022)